# EUROPEAN PATENT APPLICATION

(11) **EP 4 170 695 A1**
(43) Date of publication of application: **26.04.2023**
(21) Application number: 21203434.2
(22) Date of filing: 19.10.2021
(51) Int. Cl.: H01J 37/244

(54) **DETECTOR ASSEMBLY, CHARGED PARTICLE DEVICE, APPARATUS, AND METHODS**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

The present application discloses detector assembly for a charged particle assessment apparatus, the detector assembly comprising a plurality of electrode elements, each electrode element having a major surface configured to be exposed to signal particles emitted from a sample, wherein between adjacent electrode elements is a recess that is recessed relative to the major surfaces of the electrode elements, and wherein at least one of the electrode elements is a detection element configured to detect signal particles and the recess extends laterally behind the detection element. Charged particle assessment devices and apparatus, and corresponding methods are also provided.

## Description

### FIELD

The embodiments provided herein generally relate to detector assemblies, charged particle devices, charged particle assessment apparatus, and methods.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal particles, e.g. electrons, to be emitted from the surface, such as secondary electrons, backscattered electrons or Auger electrons. The generated signal particles may be emitted from the material structure of the sample. By scanning the primary electron beam as the probing spot over the sample surface, signal particles can be emitted across the surface of the sample. By collecting these emitted signal particles from the sample surface, a pattern inspection tool may obtain data representing characteristics of the material structure of the surface of the sample. The data may be referred to as an image and may be rendered into an image.

The emitted signal particles can generally be collected by a detector which is part of the inspection tool. Such detectors need to be able to detect very small currents in order to effectively detect the signal particles. However, contamination of the detector may occur which can affect the ability of the detector to detect the signal particles.

### SUMMARY

It is an object of the present disclosure to provide embodiments for reducing build-up of contamination that may otherwise affect the detection of charged particles emitted from a sample.

According to an aspect of the invention, there is provided a detector assembly for a charged particle assessment apparatus, the detector assembly comprising a plurality of electrode elements, each electrode element having a major surface configured to be exposed to signal particles emitted from a sample, wherein between adjacent electrode elements is a recess that is recessed relative to the major surfaces of the electrode elements, and wherein at least one of the electrode elements is a detection element configured to detect signal particles and the recess extends laterally behind the detection element.

According to an aspect of the invention, there is provided a detector assembly for a charged particle assessment apparatus, the detector assembly comprising a plurality of detector elements each configured to detect signal electrons, each detector element having a major surface configured to face towards a sample support configured to support a sample, the detector elements being arranged in a two dimensional array wherein adjoining each detector electrode is a recessed surface that is recessed relative to the major surface of the respective detector electrode, the recessed surface extending behind at least the respective detector electrode.

According to an aspect of the invention, there is provided charged particle assessment device for detecting signal particles emitted by a sample in response to a charged particle beam, the assessment apparatus comprising: an objective lens configured to project the charged particle beam onto the sample; and the detector assembly described herein.

According to an aspect of the invention, there is provided a charged particle assessment device for detecting signal particles emitted by a sample in response to a charged particle beam, the assessment apparatus comprising: an objective lens configured to project the charged particle beam onto the sample; and the detector assembly described herein, wherein an aperture is defined in the objective lens for the charged particle beam and the detector assembly defines a corresponding aperture, preferably wherein the electrode elements are arranged around the aperture

According to an aspect of the invention, there is provided a charged particle assessment device for detecting signal particles emitted by a sample in response to a plurality of charged particle beams, the assessment apparatus comprising: an objective lens array configured to project a plurality of charged particle beams onto a sample in a multi-beam array; and the detector assembly described herein.

According to an aspect of the invention, there is provided a charged particle assessment device for detecting signal particles emitted by a sample in response to a plurality of charged particle beams, the assessment apparatus comprising: an objective lens array configured to project a plurality of charged particle beams onto a sample in a multi-beam array; and the detector assembly described herein, wherein in the objective lens array is defined an aperture for at least one charged particle beam and in the detector assembly is defined a corresponding aperture, preferably wherein at least one detector element corresponds to each charged particle beam.

According to an aspect of the invention, there is provided an assessment apparatus for detecting signal particles emitted by a sample in response to a charged particle beam, the assessment apparatus comprising: an assessment device described herein or an assessment device comprising a detector assembly described here; and a support for supporting the sample.

According to an aspect of the invention, there is provided a method of projecting a beam of charged particles onto a sample so as to detect signal particles emitted from the sample, the method comprising: a) projecting the charged particle beam along a primary beam path onto a surface of the sample; and b) detecting signal particles at a detector assembly, the detector assembly comprising a plurality of electrode elements, each electrode element having a major surface configured to be exposed to signal particles emitted from a sample, wherein between the electrode elements is a recess that is recessed relative to the major surfaces of the electrode elements, and wherein at least one of the electrode elements is a detection element configured to detect signal particles and the recess extends laterally behind the detection element.

According to an aspect of the invention, there is provided a method of processing a resist covered sample comprising projecting a patterned beam of (preferably photonic) radiation onto the resist covered sample so as to pattern the resist on the sample, and further comprising carrying out the method described herein.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a schematic cross-sectional view of an objective lens according to an embodiment.
**FIG. 5** is a schematic diagram of an exemplary charged particle optical device according to an embodiment.

**FIG. 6A** and **FIG. 6B** show a bottom view of variations of a detector.
**FIG. 7** is bottom view of the portion of the objective lens array of **FIG. 4****.**
**FIG. 8** is a schematic cross-sectional view of an objective lens comprising detectors located in various positions along a beam path.
**FIG. 9** is a schematic diagram of an exemplary charged particle-optical system comprising a macro collimator and macro scan deflector.
**FIG. 10** is a schematic diagram of an exemplary single beam apparatus according to an embodiment.
**FIGS. 11A,** and **11B** are schematic representations of a detector array and an associated cell array according an embodiment, a schematic representation of a cell of the cell array, and a cell of the cell array according to an embodiment.
**FIG. 12** is a schematic representation of a cross-section wiring route showing circuit wires and a shielding arrangement according to an embodiment.
**FIG. 13** is a cross-section of a detector assembly according to an embodiment.
**FIG. 14** is a cross-section of a detector assembly according to an embodiment.
**FIG. 15** is a cross-section of a detector assembly according to an embodiment.
**FIGS. 16A, 16B** and **16C** are schematic representations of a detector assembly according to an embodiment.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal particles, e.g. secondary electrons. The detection apparatus captures the signal particles from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam inspection apparatus can therefore inspect a sample at a much higher speed than a single-beam inspection apparatus. An implementation of a known multi-beam inspection apparatus is described below.

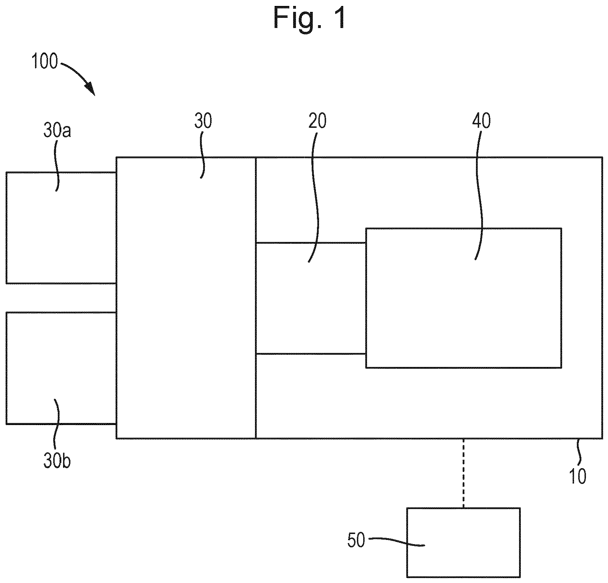

Reference is now made to **FIG. 1****,** which is a schematic diagram illustrating an exemplary charged particle beam inspection apparatus 100. The charged particle beam inspection apparatus 100 of **FIG.** 1 includes a main chamber 10, a load lock chamber 20, an charged particle beam tool 40 (which may otherwise be referred to as an electron beam tool), an equipment front end module (EFEM) 30 and a controller 50. The charged particle beam tool 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. After reaching the first pressure below the atmospheric pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second lower pressure. After reaching the second pressure, the sample is transported to the charged particle beam tool 40 by which it may be inspected. Depending on the configuration used, the second pressure may be deeper than between 10⁻⁷ to 10⁻⁵ mbar. An charged particle beam tool 40 may comprise a multi-beam charged particle -optical apparatus.

The controller 50 is electronically connected to the charged particle beam tool 40. The controller 50 may be a processor (such as a computer) configured to control the charged particle beam inspection apparatus 100. The controller 50 may include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing a charged particle beam inspection tool, it should be noted that aspects of the disclosure in their broadest sense are not limited to a chamber housing an charged particle beam inspection tool. Rather, it is appreciated that the foregoing principles may also be applied to other tools and other arrangements of apparatus, that operate under the second pressure.

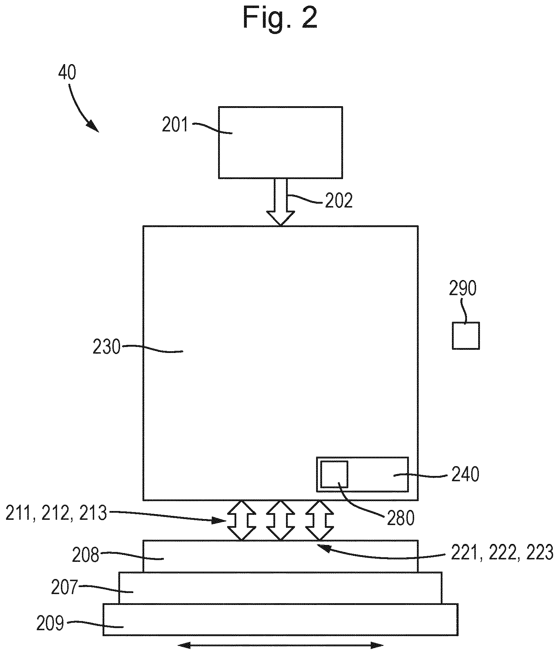

Reference is now made to **FIG. 2****,** which is a schematic diagram illustrating an exemplary charged particle beam tool 40 including a multi-beam inspection tool that is part of the exemplary charged particle beam inspection apparatus 100 of **FIG. 1****.** The multi-beam charged particle beam tool 40 (also referred to herein as apparatus 40) comprises an charged particle source 201, a projection apparatus 230, a motorized stage 209, and a sample holder 207. The charged particle source 201 and projection apparatus 230 may together be referred to as an illumination apparatus. The sample holder 207 is supported by motorized stage 209 so as to hold a sample 208 (e.g., a substrate or a mask) for inspection. The multi-beam charged particle beam tool 40 further comprises a detector array 240 (e.g. an electron detection device).

The controller 50 may be connected to various parts of the charged particle beam inspection apparatus 100 of **FIG. 1****.** The controller 50 may be connected to various parts of the charged particle beam tool 40 of **FIG. 2****,** such as the charged particle source 201, the detector array 240, the projection apparatus 230, and the motorized stage 209. The controller 50 may perform various data, image and/or signal processing functions. The controller 50 may also generate various control signals to govern operations of the charged particle beam inspection apparatus 100, including the charged particle multi-beam apparatus. The controller 50 may control the motorized stage 209 to move sample 208 during inspection of the sample 208. The controller 50 may enable the motorized stage 209 to move the sample 208 in a direction, for example continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns and their associated charged particle-optics.

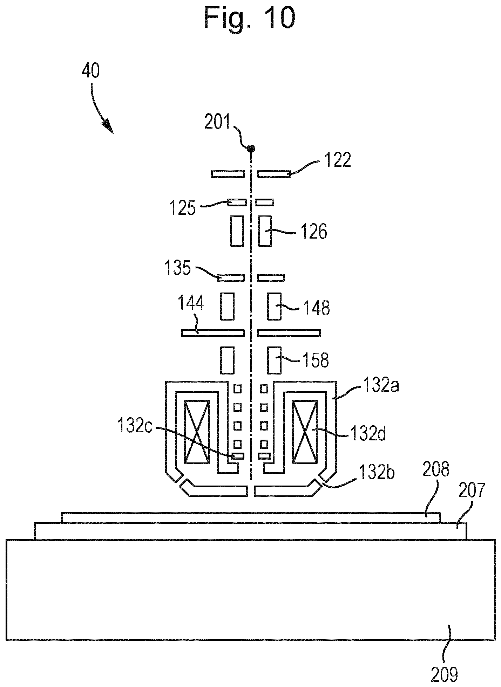

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. Such a single beam system is described further below in relation to **FIG. 10** , but it will be noted that the sub-beams may be generally interchangeable with a single primary charged particle beam 202.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The secondary signal particles typically have charged particle energy ≤ 50 eV. Actual secondary signal particles can have an energy of less than 5 eV, but anything beneath 50 eV is generally treated as a secondary signal particle. Backscatter signal particles typically have energy between 0 eV and the landing energy of the primary sub-beams 211, 212, and 213. As signal particles detected with an energy of less than 50 eV are generally treated as a secondary signal particles, a proportion of the actual backscatter signal particles will be counted as secondary signal particles. The secondary signal particles may more specifically be referred to, and are interchangeable with, secondary electrons. The backscatter signal particles may more specifically be referred to, and are interchangeable with, backscatter electrons. The skilled person would understand that the backscatter signal particles may more generally be described as secondary signal particles. However, for the purposes of the present disclosure, the backscatter signal particles are considered to be different from the secondary signal particles, e.g. having higher energies. In other words, the secondary signal particles will be understood to be particles having kinetic energy ≤ 50 eV (i.e. less than or equal to 50 eV) when emitted from the sampled and the backscatter signal particles will be understood to be particles having kinetic energy higher than 50 eV when emitted from the sample. In practice, the signal particles may be accelerated before being detected and thus, the energy range associated with the signal particles may be slightly higher. For example, in an embodiment the secondary signal particles will be understood to be particles having kinetic energy ≤ 200 eV when detected at a detector and the backscatter signal particles will be understood to be particles having kinetic energy higher than 200 eV when detected at a detector. It is noted that the 200 eV value may vary depending on the extent of acceleration of the particles, and may for example be approximately 100 eV or 300 eV. Secondary signal particles having such values are still considered to have sufficient energy different with respect to the backscatter signal particles.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 could otherwise be referred to as an image processing system or a data processing system. The signal processing system may be incorporated into a component of the multi-beam charged particle beam tool 40 such as the detector array 240 (as shown in **FIG. 2**). However, the signal processing system 280 may be incorporated into any components of the inspection apparatus 100 or multi-beam charged particle beam tool 40, such as, as part of the projection apparatus 230 or the controller 50. The signal processing system 280 could be located outside of the structure that includes the main chamber which is shown in **FIG. 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam tool 40 and charged particle beam inspection apparatus 100 described above, are disclosed in US2020118784, US20200203116, US 2019/0259570 and US2019/0259564 which are hereby incorporated by reference.

In known single-beam systems, different signals (e.g. from secondary signal particles and/or backscatter signal particles) might theoretically be detected. Detection of backscatter signal particles can be beneficial in providing information about structures underneath the surface, such as buried defects, rather than surface features detected using secondary signal particles. Additionally, backscatter signals can be used to measure overlay targets. Multi-beam systems are known and are beneficial as the throughput can be much higher than when using single-beam systems, e.g. the throughput of a multi-beam inspection system may be 100 times higher than the throughput in a single-beam inspection system.

Backscatter signal particles have a large range of energies, typically between 0 eV and the landing energy of for example the primary beam. Backscatter signal particles have a wide angle of emission from a sample. Secondary signal particles typically have a more restricted energy range and tend to be distributed around an energy value. Cross-talk occurs when signal particles, and more likely backscatter signal particles, resulting from one primary sub-beam are detected at a detector assigned to a different sub-beam. Thus, cross-talk can impact performance of a detector for imaging signal particles.

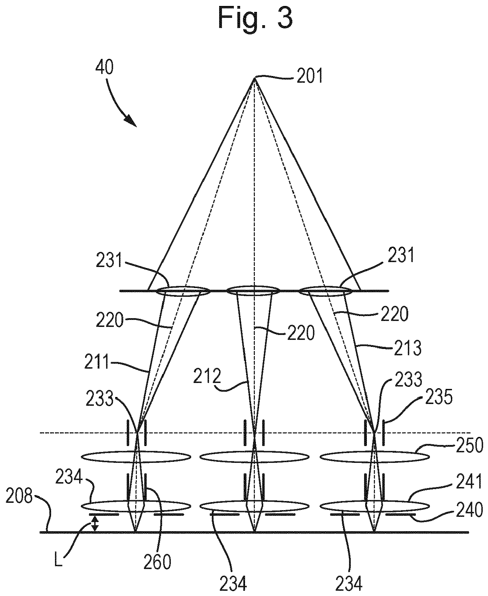

Components of an assessment tool 40 which may be used in the present invention are described below in relation to **FIG. 3** which is a schematic diagram of an assessment tool 40. The charged particle assessment tool 40 of **FIG. 3** may correspond to the multi-beam charged particle beam tool (also referred to herein as apparatus 40).

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. More generally, the condenser lens array 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lens array may be connected and/or spaced apart from an adjacent charged particle-optical element, preferably an electrostatic charged particle-optical element, by an isolating element such as a spacer as described elsewhere herein.

The condenser lenses may be separated from a module containing the objective lenses (such as an objective lens array assembly as discussed elsewhere herein). In a case where the potential applied on a bottom surface of the condenser lenses is different than the potential applied on the top surface of the module containing the objective lenses an isolating element (e.g. a spacer) is used to space apart the condenser lenses and the module containing the objective lenses. In a case where the potential is equal then a conductive element can be used to space apart the condenser lenses and the module containing the objective lenses.

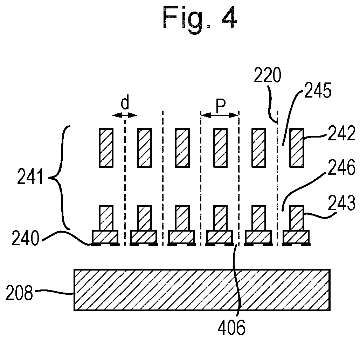

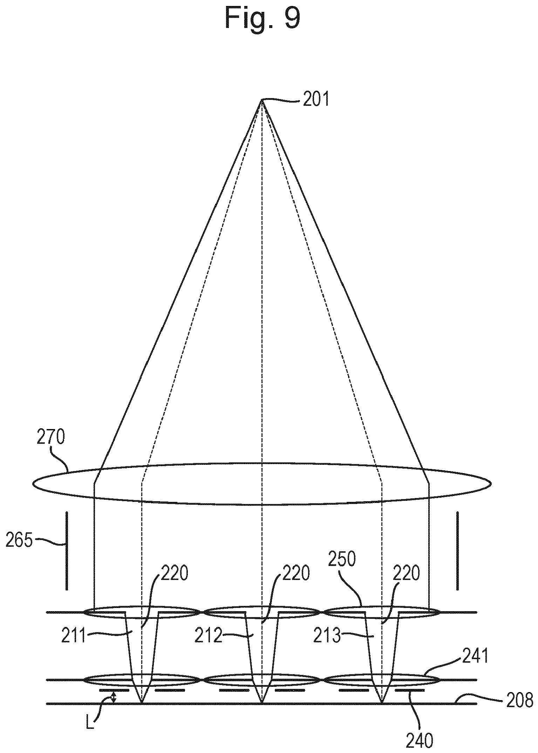

Each condenser lens 231 in the array directs a primary beam of charged particles into a respective sub-beam 211, 212, 213 which is focused at a respective intermediate focus down beam of the condenser lens array. The respective sub-beams are projected along respective sub-beam paths 220. The sub-beams diverge with respect to each other. The sub-beam paths 220 diverge down beam of the condenser lenses 231. In an embodiment, deflectors 235 are provided at the intermediate focuses. The deflectors 235 are positioned in the sub-beam paths at, or at least around, the position of the corresponding intermediate focusses 233 or focus points (i.e. points of focus). The deflectors are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270, instead of, or in addition to the deflectors 235. Thus, the macro-collimator 270 described below in relation to **FIG. 9** may be provided with the features of **FIG. 3** or **FIG. 4****.** This is generally less preferred than providing the collimator array as deflectors 235.

Below (i.e. down beam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 240 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location, for example in, on or otherwise associated with the objective lens. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array electrodes may be spaced a few millimeters (e.g. 3mm) apart. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241. Up-beam may be defined as being closer to the source 201. Up-beam may otherwise be defined as further from the sample 208. The control lens array 250 may be in the same module as an objective lens array 241, i.e. forming an objective lens array assembly or objective lens arrangement, or it may be in a separate module. In this case, the arrangement may be described as four or more lens electrodes that are plates. In the plates are defined apertures, for example as aperture arrays, that are aligned with a number of sub-beams in a corresponding beam array. The electrodes may be grouped into two or more electrodes, for example to provide a control electrode group, and an objective electrode group. In an arrangement the objective electrode group has at least three electrodes and the control electrode group has at least two electrodes. Alternatively, if the control lens array 250 and the objective lens array 240 are separate, the spacing between the control lens array 241 and the objective lens array 250 (i.e. the gap between lower electrode (or more down-beam electrode) of the control lens array 250 and the upper electrode of the objective lens 241) can be selected from a wide range, e.g. from 2 mm to 200 mm or more. A small separation makes alignment easier whereas a larger separation allows a weaker lens to be used, reducing aberrations.

Each plate electrode of the control lens array 250 is preferably mechanically connected to, and electrically separated from, an adjacent plate electrode array by an isolating element, such as a spacer which may comprise ceramic or glass. Each plate electrode of the objective lens array is preferably mechanically connected to, and electrically separated from, an adjacent plate electrode array by an isolating element, such as a spacer which may comprise ceramic or glass. The isolating element may otherwise be referred to as an insulating structure, and may be provided to separate any adjacent electrodes provided, such as in the objective lens array 240, the condenser lens array (as depicted in **FIG. 3**) and/or the control lens array 250. If more than two electrodes are provided, multiple isolating elements (i.e. insulating structures) may be provided. For example, there may be a sequence of insulating structures.

The control lens array 250 comprises a control lens for each sub-beam 211, 212, 213. A control lens adds optical degrees of freedom to the function of the associated objective lens. A control lens may comprise of one or more electrode or plates. The addition of each electrode may provide a further degree of freedom of the control of the charged particle-optical function of the associated objective lens. In an arrangement the function of the control lens array 250 is to optimize the beam opening angle with respect to the demagnification of the beam and/or to control the beam energy delivered to the objective lenses 234, each of which directs a respective sub-beam 211, 212, 213 onto the sample 208. The objective lenses may be positioned at or near the base of the charged particle-optical system. More specifically, the objective lens array may be positioned at or near the base of the projection system 230. The control lens array 250 is optional, but is preferred for optimizing a sub-beam up-beam of the objective lens array.

Thus, the control lens array 250 may be considered as providing electrodes additional to the electrodes of the objective lens array 241 for example as part of the objective lens array assembly (or objective lens arrangement). The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens.

For ease of illustration, lens arrays are depicted schematically herein by arrays of oval shapes (as shown in **FIG. 3**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The objective lens array 241 may comprise at least two electrodes in which are defined aperture arrays. In other words, the objective lens array comprises at least two electrodes with a plurality of holes or apertures. Adjacent electrodes of the objective lens array 241 are spaced apart from each other along the sub-beam paths. The distance between adjacent electrodes along the beam path, in which an insulating structure might be positioned as described below, is smaller than the size of an objective lens (along the beam path, i.e. between the most upbeam and most down beam electrode of the objective lens array). **FIG. 4** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of sub-beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The aperture arrays 245, 246 of the objective lens array 241 may consist of a plurality of apertures, preferably with substantially uniform diameters, d. However there may be some variation for optimizing aberration correction as described in EP Application 20207178.3 filed on 12 November 2020 which is herein incorporated by reference at least with respect to corrections achieved by varying aperture diameter. The diameter, d, of the apertures in at least one electrode may be less than approximately 400 µm. Preferably, the diameter, d, of the apertures in at least one electrode is between approximately 30 to 300 µm. The plurality of apertures in an electrode may be spaced apart from each other by a pitch, P. The pitch, P, is defined as the distance from the middle of one aperture to the middle of an adjacent aperture. The pitch between adjacent apertures in at least one electrode may be less than approximately 600 µm. Preferably, the pitch between adjacent apertures in at least one electrode is between approximately 50 µm and 500 µm. Preferably, the pitch between adjacent apertures on each electrode is substantially uniform. The values for the diameter and/or pitch described above can be provided in at least one electrode, multiple electrodes, or all electrodes in an objective lens array. Preferably, the dimensions referred to and described apply to all electrodes provided in an array of objective lenses.

The objective lens array 241 may comprise two or three electrodes or may have more electrodes (not shown). An objective lens array 241 having only two electrodes can have fewer aberrations, e.g. a lower aberration risk and/or impact, than an objective lens array 241 having more electrodes. A three-electrode objective lens can have greater potential differences between the electrodes and so enable a stronger lens. Additional electrodes (i.e. more than two electrodes) provide additional degrees of freedom for controlling the charged particle trajectories, e.g. to focus secondary signal particles as well as the incident beam. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array. The objective lens array 241 can be configured to demagnify the charged particle beam by a factor greater than 10, desirably in the range of 50 to 100 or more. Each element in the objective lens array 240 may be a micro-lens operating a different sub-beam or group of sub-beams in the multi-beam.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

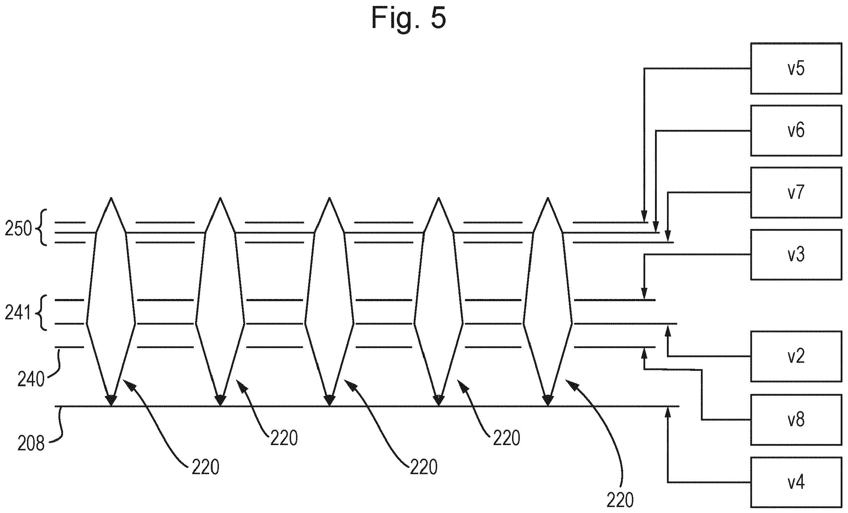

**FIG. 5** is an enlarged schematic view of multiple objective lenses of the objective lens array 241 and multiple control lenses of the control lens array 250. As described in further detail below, the lens arrays can be provided by electrodes with a selected potential applied to the electrode by a voltage source, i.e. electrodes of the arrays are connected to respective potential sources. In **FIG. 5****,** multiple lenses of each of the control lens array 250, the objective lens array 241 and the detector array 240 are depicted, for example, with any of sub-beams 211, 212, 213 passing through the lenses as shown. Although **FIG. 5** depicts five lenses, any appropriate number may be provided; for example, in the plane of the lenses, there may be 100, 1000 or of the order of 10,000 lenses. Features that are the same as those described above are given the same reference numerals. For conciseness, the description of these features provided above applies to the features shown in **FIG. 5****.** The charged particle optical device may comprise one, some or all of the components shown in **FIG. 5****.** Note that this figure is schematic and may not be to scale. For example, in a non-limited list: the sub-beams may be narrower at the controller array 250 than at the objective lens array 241; and the detector array 240 may be closer to the electrodes of the objective lens array 241 than the electrodes of the objective lens array 241 are to each other. Spacing between electrodes of the control lens array 250 may be larger than spacing between electrodes of the objective lens array 241 as shown in **FIG. 5****,** but this is not a necessity.

The same components of **FIG. 5** may be used in a configuration as shown in **FIG. 9****,** in which case, the sub-beams may be separated (or generated) from a beam from a source further down beam. For example, the sub-beams may be defined by a beam limiting aperture array which may be part of a lens arrangement such as an objective lens array, a control lens array, or any other lens element that may be associated with an objective lens array for example that is part of an objective lens array assembly. As depicted in **FIG. 9**, the sub-beams may be separated from the beam from the source by a beam limiting aperture array that may be part of the control lens array 250 as a most up beam electrode of the control lens array 250.

Voltage sources V3 and V2 (which may be provided by individual electric power sources, or may all be supplied by electric power source 290) are configured to apply potentials to the upper and lower electrodes of the objective lens array 241 respectively. The upper and lower electrodes may be referred to as an up-beam electrode 242 and a down-beam electrode 243 respectively. Voltage sources V5, V6, V7 (which may be provided by individual electric power sources, or may all be supplied by electric power source 290) are configured to apply potentials to the first, second and third electrodes of the control lens array 250 respectively. A further voltage source V4 is connected to the sample to apply a sample potential. A further voltage source V8 is connected to the detector array to apply a detector array potential. Although the control lens array 250 is shown with three electrodes, the control lens array 250 may be provided with two electrodes (or more than three electrodes). Although the objective lens array 240 is shown with two electrodes, the objective lens array 240 may be provided with three electrodes (or more than three electrodes). For example, a middle electrode may be provided in the objective lens array 241 between the electrodes shown in **FIG. 5** with a corresponding voltage source, V1 (not shown).

Desirably, the potential V5 of the uppermost electrode of the control lens array 250 is maintained the same as the potential of the next charged particle-optic element up-beam of the control lens (e.g. deflectors 235). The potential V7 applied to the lower electrode of the control lens array 250 can be varied to determine the beam energy. The potential V6 applied to the middle electrode of the control lens array 250 can be varied to determine the lens strength of the control lens and hence control the opening angle and demagnification of the beam. It should be noted that even if the landing energy does not need to be changed, or is changed by other means, the control lens can be used to control the beam opening angle. The position of the focus of a sub-beam is determined by the combination of the actions of the respective control lens array 250 and the respective objective lens 240.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam. The array of detectors may correspond with the array of objective lenses. In other words, the array of detectors may be associated with the corresponding array of objective lenses. A detector array 240 is described below. However, any reference to detector array 240 could be replaced with a single detector (i.e. at least one detector) or multiple detectors as appropriate. The detectors may otherwise be referred to as of detector elements 405 (e.g. sensor elements such as capture electrodes). The detectors may be any appropriate type of detector.

The detector array 240 may be positioned at a position along the primary beam path at any location between an upper beam position and a lower beam position along the beam path. The upper beam position is above the objective lens array and optionally any associated lens arrays such as a control lens array (i.e. up beam of an objective lens array assembly). The lower beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

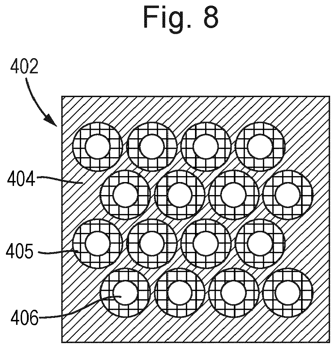

In an arrangement the detector array 240 may be positioned between the control lens array 250 and the sample 208. The detector array 240 may be positioned between the objective lenses 234 and the sample 208, as shown in **FIG. 4** and **FIG. 5****.** Although this may be preferable, the detector array 240 could be provided in additional or alternative locations, such as those depicted in **FIG. 8****.** Multiple detector arrays may be provided in a variety of locations, e.g. as in **FIG. 8****.** The signal particles, such as backscatter signal particles and secondary signal particles may be detected directly from the surface of the sample 208. Thus, the backscatter signal particles may be detected without having to be converted, for example, into another type of signal particle such a secondary signal particle which may be easier to detect. Thus, the backscatter signal particles may be detected by the detector array 240 without requiring an intermediate detection component to generate detection signal for the backscatter signal particles.

The detector array 240 may be positioned proximate and/or adjacent the sample. The detector being proximate and/or adjacent the sample enables the risk of cross-talk in detection of signal particles generated by sub-beams which correspond to another detector in the detector array to be reduced if not avoided. Note this problem is more significant for backscatter signal particles than secondary signal particles. It is also noted that proximity to the sample surface may increase the chance of contamination being generated and forming on the detector array, especially for a resist covered sample.

The detector array 240 may be within a certain distance of the sample 208, e.g. close to the sample. For preferentially detecting backscatter particles, the detector array 240 may be very close to the sample 208 such that there is a proximity focus of backscatter signal particles at the detector array. The at least one detector may be positioned in the device so as to face the sample. Thus, the at least one detector may be configured to face towards a sample support configured to support the sample 208, e.g. the sample holder 207. That is the detector may provide a base to the device. The detector as part of the base may face a surface of the sample. -For example, the at least one detector array may be provided on an output side of the objective lens array 241. The output side of the objective lens array 241 is the side on which the sub-beams are output from the objective lens array 241, i.e. the bottom or downbeam side of the objective lens array in the configuration shown in **FIG. 3****,** **FIG. 4** and **FIG. 5****.** In other words, the detector array 240 may be provided downbeam of the objective lens array 241. The detector array may be positioned on, or adjacent to, the objective lens array. The detector array 241 may be an integral component of the objective lens array 241. The detector and objective lens may be part of the same structure. The detector may be connected to the lens by an isolating element or directly to an electrode of the objective lens. Thus, the at least one detector may be part of an objective lens assembly comprising at least the objective lens array and the detector array. If the detector array is an integral component of the objective lens array 241, the detector array 240 may be provided at the base of the objective lens array 241. In an arrangement the detector array 240 may be integral to the most-down-beam positioned electrode of the objective lens array 241.

Preferably, a distance 'L' as shown in **FIG. 3****,** between the detector array 240 and the sample 208 is less than or equal to approximately 50 µm, i.e. the detector array 240 is positioned within approximately 50 µm from the sample 208. Generally the distance L is small so to ensure detector efficiency and/or reduce cross-talk, for example between 5 and 200 micron, approximately 100 micron or less, e.g. between around 10 to 65 microns The distance L is determined as the distance from a surface of the sample 208 facing the detector array 240 and a surface of the detector array 241 facing the sample 208. To preferentially detect backscatter signal particles, the detector may be positioned with a smaller distance range between the detector and the sample, for example between 5 and 50 micron, because a distance of approximately 50 µm or less is beneficial in that cross-talk between backscatter signal particles can be avoided or minimized. It is noted that the distance L described here is for a multi-beam system as shown in **FIG.** 3 (or **FIG. 9**). The same distance may be used in a single beam device, e.g. as shown in **FIG. 10****,** although the distance L may be larger for the single beam device.

Preferably, the pitch of the sub-beams and distance L are selected such that the signal particle signals of the neighbouring sub-beams to not overlap; that is cross-talk is reduced if not avoided. Thus, the pitch size, P, as discussed above may be selected depending on the distance between the detector array 240 and the sample 208 (or vice versa). For example only, the distance L between the sample 208 an the detector array 240 is approximately 50 micron and the sub-beam pitch p is approximately 60 micron. Such a combination may be particularly useful for detecting low energy signal particles, e.g. secondary signal particles, with a decelerating lens. In a different example arrangement, for a distance L between the sample 208 and the detector array 240 of approximately 50 micron, the sub-beam pitch p may be equal to or larger than approximately 300 micron. Such a different set up is intended for different operational settings and to detect a different type of signal particle. For example, such a combination may be particularly useful for detecting high energy signal particles, e.g. backscatter signal particles, with an accelerating lens. For simultaneous detection of high energy particles (e.g. backscatter signal particles) and low energy particles (e.g. secondary signal particles), the pitch p and distance L may be selected between the values described above so that the high energy particle and low energy particle signals are sufficiently large. It will be noted that there is no relation or limitation for the distance L and the pitch p for the functioning of the detector. However, due to a risk of crosstalk in neighboring detectors it might be preferable to use a larger pitch p for a larger distance L. Although, there may also be other ways to reduce the risk of crosstalk and any appropriate combination of pitch p and distance L may be used.

The objective lens array 241 may be configured to decelerate the primary charged particles (i.e. the sub-beams) towards the sample 208 along the sub-beam paths 220. For example, the device being configured to decelerate the charged particle sub-beams may have potentials as shown in the context of **FIG. 5** with the values in Table 1 below, with the function of the lens arrangement corresponding to the arrangement herein described. For example only, the charged particles may be decelerated from 30kV to 2.5kV in the objective lens. In an example, to obtain landing energies in the range of 1.5 kV to 5 kV, potentials shown in **FIG. 5****,** such as V2, V3, V4, V5, V6 and V7, can be set as indicated in Table 1 below. V1 is optionally included if a middle objective lens electrode is included. The potentials and landing energies shown in Table 1 are examples only and other landing energies could be obtained, for example, the landing energy could be lower than 1.5 kV (e.g. approximately 0.3 kV or 0.5 kV) or higher than 5 kV. It will be seen that the beam energy at V1, V3 and V7 is the same. In embodiments the beam energy at these points may be between 10 keV and 50 keV. If a lower potential is selected, the electrode spacings may be reduced, especially in the objective lens, to limit reduction of the electric fields. The potentials in this table are given as values of beam energy in keV, which is equivalent to the electrode potential relative to the cathode of the beam source 201. It will be understood that in designing a charged particle-optical system there is considerable design freedom as to which point in the system is set to a ground potential and the operation of the system is determined by potential differences rather than absolute potentials.

**Table 2**

| | | | | |
|---|---|---|---|---|
| Landing Energy | 1.5 keV | 2.5 keV | 3.5 keV | 5 keV |
| V1 (or omitted) | 29 keV | 30 keV | 31 keV | 30 keV |
| V2 | 1.55 keV | 2.55 keV | 3.55 keV | 5.05 keV |
| V3 | 29 keV | 30 keV | 31 keV | 30 keV |
| V4 | 1.5 keV | 2.5 keV | 3.5 keV | 5 keV |
| V5 | 30 keV | 30 keV | 30 keV | 30 keV |
| V6 | 19.3 keV | 20.1 keV | 20.9 keV | 30 keV |
| V7 | 29 keV | 30 keV | 31 keV | 30 keV |
| V8 | 1.55 keV | 2.55 keV | 3.55 keV | 5.05 keV |

The potentials and the values of the potentials defined herein are defined with respect to the source; hence the potential of a charged particle at the surface of the sample may be referred to as a landing energy because the energy of a charged particle correlates to the potential of the charged particle and the potential of the charged particle at the sample is defined with respect to the source. However, as the potentials are relative values, the potentials could be defined relative to other components, such as the sample. In this instance, the difference in potential applied to different components would preferably be as discussed below with respect to the source. The potentials are applied to the relevant components, such as the electrodes and the samples during use, i.e. when the device is being operated.

It is noted that a decelerating lens in the arrangement may be particularly useful for detecting both secondary and backscatter signal particles. The figures described herein, and particularly **FIGS. 3****,** 5 and **9****,** show the objective lens in the decelerating mode. However, as will be understood from the description below, the objective lens may be used in the accelerating mode instead for any of the embodiments and variations described below. In other words, **FIGS. 3****,** 5 and 9 could be adapted to accelerate the sub-beams through the objective lenses.

The detector array 240 (and optionally the objective lens array 241) may be configured to repel secondary signal particles emitted from the sample 208. This is beneficial when preferentially detecting backscatter signal particles as it reduces the number of secondary signal particles emitted from the sample 208 which travel back towards the detector array 240.. The difference in potential between the detector array 240 and the sample 208 can be selected to repel signal particles emitted from the sample 208 away from the detector array 240. Preferably, the detector array potential may be the same as the potential of the downbeam electrode of the objective lens array. The potential difference between the sample potential and the detector array potential is preferably relatively small so that primary sub-beams are projected through or past the detector array 240 to the sample 208 without being significantly affected. Additionally, a small potential difference will have a negligible effect on the path of a backscatter signal particle (which generally has a greater energy up to the landing energy), meaning that the backscatter signal particles can still be detected whilst reducing or avoiding detection of secondary signal particles. The potential difference between the sample potential and the detector array potential is preferably greater than a secondary signal particle threshold. The secondary signal particle threshold may determine the minimum initial energy of secondary signal particles that can still reach the detector. The relatively small potential difference between the sample and detector array potentials is sufficient to repel the secondary signal particles from the detector array. For example, the potential difference between the sample potential and the detector array potential may be approximately 20 V, 50 V, 100 V, 150 V, 200 V, 250 V, or 300V.

The objective lens array 241 may be configured to accelerate the primary charged particles (i.e. the sub-beams) towards the sample 208 along the sub-beam paths 220. Accelerating the sub-beams 211, 212, 213 projected onto the sample 208 is beneficial in that it can be used to generate an array of sub-beams with high landing energy. The potentials of the electrodes of the objective lens array can be selected to provide acceleration through the objective lens array 241. It is noted that an accelerating lens in the arrangement may be particularly useful for detecting ranges (e.g. different energy ranges) of backscatter signal particles.

In an arrangement of accelerating objective lens array 241, the low energy particles (e.g. secondary signal particles) generally cannot pass up-beam of the lower part (or more down-beam part) of the accelerating objective lens. It is also increasing difficult for high energy particles (e.g. backscatter signal particles) to pass the accelerating objective lens. The energy difference between the low energy signal particles (e.g. secondary signal particles) and high energy signal particles (e.g. backscatter signal particles) is proportionately larger down-beam of the objective lens (in both accelerating and decelerating mode) than at any point up-beam of the objective lens. This is beneficial for detection using the detectors described below to distinguish between the different types of signal particles.

For example, the device being configured to accelerate the charged particle sub-beams and repel the secondary signal particles as described above may have potentials as shown in the context of **FIG. 5** with the values in Table 2 below, noting **FIG. 5** shows a decelerating lens arrangement rather than functioning as an accelerating lens herein described . The values of the potentials provided for the decelerating lens might be swapped and adjusted to provide acceleration. As mentioned above, the objective lens array as shown in **FIG. 5** may comprise an additional electrode, e.g. a middle electrode. Such a middle electrode is optional and need not be included with the electrodes having the other potentials listed in Table 2. The middle electrode of the objective lens array may have the same potential (e.g. VI) as the upper electrode of the objective lens array (i.e. V3).

Exemplary ranges are shown in the left hand column of Table 1 as described above. The middle and right hand columns show more specific example values for each of V1 to V8 within the example ranges. The middle column may be provided for a smaller resolution than the right hand column. If the resolution is larger (as in the right hand column), the current per sub-beam is larger and therefore, the number of sub-beams may be lower. The advantage of using a larger resolution is that the time needed to scan a "continuous area" is shorter (which can be a practical constraint). So the overall throughput may be lower, but the time needed to scan the beam area is shorter (because the beam area is smaller).

**Table 1**

| | | | |
|---|---|---|---|
| Landing Energy | >10-100 keV | 30 keV | 30 keV |
| V1 (or omitted) | 1-10 keV | 5 keV | 5 keV |
| V2 | >10-100 keV | 29.95 keV | 29.95 keV |
| V3 | 1-10 keV | 5 keV | 5 keV |
| V4 | >10-100 keV | 30 keV | 30 keV |
| V5 | >10-100 keV | 30 keV | 30 keV |
| V6 | 1-30 keV | 4.4 keV | 10 keV |
| V7 | 1-10 keV | 5 keV | 5 keV |
| V8 | >10-100 keV | 29.95 keV | 29.95 keV |

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). In an embodiment the outer shape of the detector element 405 is a circle, but this can be made a square or a hexagon to maximize the detection area.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (e.g. annular or ring-shaped) detector element 405 may provide a good compromise between collection efficiency and parasitic capacitance. A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In some embodiments, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment tool. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream (or down-beam). The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. The objective lenses and/or control lenses and correctors may be part of the same structure. For example they may be connected to each other, for example with an electrically isolating element. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment, a single detector element 405 surrounds each beam aperture 406. In another embodiment, a plurality of detector elements 405 are provided around each beam aperture 406. Thus, the detector comprises multiple portions, and more specifically, multiple detecting portions. The plurality of detector portions may, together, have a circular perimeter and/or a diameter. The plurality of detector portions may, together, have an area extending between the aperture and the perimeter of the plurality of detector portions. The different portions may be referred to as different zones. Thus the detector may be described to have multiple zones or detection zones. Such a detector may be referred to as a zoned detector. The signal particles captured by the detector elements 405 surrounding one beam aperture 406 may be combined into a single signal or used to generate independent signals. The surfaces of the detector elements, optionally their detector portions, may substantially fill the surface of the substrate supporting the detector elements. The detector comprising multiple portions may be provided in any of the detector arrays described herein.

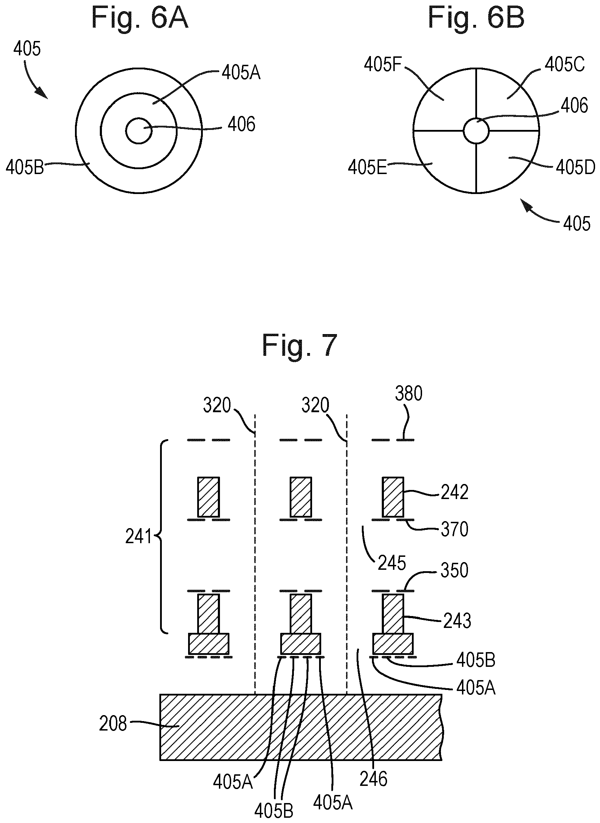

The zoned detector may be associated with one of the sub-beams 211, 212, 213. Thus, the multiple portions of one detector may be configured to detect signal particles emitted from the sample 208 in relation to one of the sub-beams 211, 212, 213. The detector comprising multiple portions may be associated with one of the apertures in at least one of the electrodes of the objective lens assembly. More specifically, the detector 405 comprising multiple portions may be arranged around a single aperture 406 as shown in **FIG.** 6A and **FIG. 6B****,** which provide examples of such a detector.

The portions of the zoned detector may be separated in a variety of different ways, e.g. radially, annular, or any other appropriate way. Preferably the portions are of similar angular size and/or similar area and/or similar shape, for example as shown in **FIG. 6B****.** The separated portions may be provided as a plurality of segments, a plurality of annular portions (e.g. a plurality of concentric annuli or rings), and/or a plurality of sector portions (i.e. radial portions or sectors). The detector elements 405 may be divided radially. For example, the at least one detector 405 may be provided as annular portions comprising 2, 3, 4, or more portions. More specifically, as shown in **FIG. 6A****,** the detector 405 may comprise an inner annular portion 405A surrounding aperture 406 and an outer annular portion 405B, radially outwards of the inner annular portion 405A. Alternatively, the detector elements 405 may be divided angularly. For example, the detector may be provided as sector portions comprising 2, 3, 4, or more portions, for example 8, 12 etc.. If the detector is provided as two sectors, each sector portion may be a semi-circle. If the detector is provided as four sectors, each sector portion may be a quadrant. This is shown in **FIG. 6B** in which the 405 is divided into quadrants, i.e. four sector portions is shown in **FIG. 6B****,** as described below. Alternatively, the detector may be provided with at least one segment portion. The electrode elements may be separated both radially and angularly (e.g. in a dart board arrangement) or in any other convenient manner.

Each portion may have a separate signal read-out. The detector being separated into portions, e.g. annular portions or sector portions, is beneficial in that it allows more information to be obtained in relation to the signal particles detected. Thus, providing the detector 405 with multiple portions may be beneficial in obtaining additional information relating to the detected signal particles. This can be used to improve the signal to noise ratio of the detected signal particles. However, there is an additional cost in terms of the complexity of the detector.

As shown in **FIG. 6A****,** the detector, in which an aperture 406 is defined and configured for the through passage of a charged particle beam, comprises inner detecting portion 405A and outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. In an example, the detector may be divided into two (or more) concentric rings, for example, as depicted in **FIG. 6A****.**

Providing multiple portions concentrically or otherwise may be beneficial because different portions of the detector may be used to detect different signal particles, which may be smaller angle signal particles and/or larger angle signal particles, or secondary signal particles and/or backscatter signal particles. Such a configuration of different signal particles may suit a concentrically zoned detector. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

**FIG. 7** is a bottom view (i.e. a plan view) of detector array 240 which comprises a substrate 404 on which are provided a plurality of detector electrodes 405 each surrounding a beam aperture 406. The beam apertures 406 may be formed by etching through substrate 404. In the arrangement shown in **FIG. 7****,** the beam apertures 406 are shown in a hexagonal close packed array. The beam apertures 406 can also be differently arranged, e.g. in a rectangular array. The detector electrodes 405 are isolated from each other by a gap between the detector electrodes 405. Furthermore, the substrate 404 isolates the detector elements 404 from each other, and could otherwise be referred to as an isolating element.

**FIG. 8** is a schematic diagram of an exemplary charged particle-optical system having the charged particle device as in any of the above described options or aspects. The charged particle optical device having at least the objective lens array 241 as described in any of the aspects or embodiments above may be used in the charged particle-optical system as shown in **FIG. 9****.** For conciseness, features of the objective lens array 241 that have already been described above may not be repeated here.

There are some considerations specific to the set up of **FIG. 9****.** In the present embodiment, it is preferable to keep the pitch small so as to avoid negatively impacting throughput. However, when the pitch is too small, this can lead to cross-talk. Therefore, the pitch size is a balance of effective detection of a selected signal particle such as a backscatter signal particle and throughput. Thus, the pitch is preferably approximately 300 µm in such an arrangement for detection of backscatter signal particles, which is 4-5 times larger than it might otherwise be for the embodiment of **FIG. 9** when detecting secondary signal particles.

As shown in **FIG. 9****,** the charged particle-optical system comprises a source 201. The source 201 provides a beam of charged particles (e.g. electrons). The multi-beam focused on the sample 208 is derived from the beam provided by the source 201. Sub-beams 211, 212, 213 may be derived from the beam, for example, using a beam limiter (which may otherwise be referred to as a beam limiting aperture array) defining an array of beam-limiting apertures. The beam may separate into the sub-beams 211, 212, 213 on meeting the control lens array 250. The sub-beams 211, 212, 213 are substantially parallel on entry to the control lens array 250. (In an arrangement, the control lens array 250 comprises the beam limiter.) The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 collimates the beam from the source such that beam cross-section is substantially consistent on incidence with the beam limiter. The macro collimator 270 bends respective portions of the beam from which the sub-beams are derived by an amount effective to ensure that a beam axis of each of the sub-beams is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro-collimator may be partially or wholly replaced by a collimator element array provided down-beam of the upper beam limiter. Each collimator element collimates a respective sub-beam. The collimator element array may be formed using MEMS manufacturing techniques so as to be spatially compact. The collimator element array may be the first deflecting or focusing charged particle-optical array element in the beam path down-beam of the source 201. The collimator element array may be up beam of the control lens array 250. The collimator element array may be in the same module as the control lens array 250.

In the embodiment of **FIG. 9** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array 260 together, preferably in synchronization.

The invention can be applied to various different tool architectures. For example, the charged particle beam tool 40 may be a single beam tool, or may comprise a plurality of single beam columns or may comprise a plurality of columns of multi-beams (i.e. sub-beams). The columns may comprise the charged particle optical device described in any of the above embodiments or aspects. As a plurality of columns (or a multi-column tool), the devices may be arranged in an array which may number two to one hundred columns or more. The charged particle device may take the form of an embodiment as described with respect to and depicted in **FIG. 3** or as described with respect to and depicted in **FIG. 9****,** although preferably having an electrostatic scan deflector array and/or an electrostatic collimator array for example in the objective lens array assembly. The charged particle optical device may be a charged particle optical column. A charged particle column may optionally comprise a source.

As described above, the array of detectors 240 may be provided between the objective lens array 241 and the sample 208, as shown in **FIG. 4** and **FIG. 5****.** The array of detectors 240 may be associated with at least one electrode of the objective lens array, preferably, the lower electrode 243. Preferably, the down-beam array of detectors 240 faces the sample 208 in use, i.e. when the sample is present.

Additional or alternative detector arrays may be provided which may be positioned in other places. This is depicted in **FIG. 8****.** One, some or all of the detector arrays as shown in **FIG. 8** might be provided. If multiple detector arrays are provided, they may be configured to detect signal particles simultaneously. The detector array 240 positioned between the objective lens array 241 and the sample 208 is shown as a zoned detector, e.g. as described in relation to **FIGS. 6A** and **6B****.** However, any appropriate type of detector may be used for this array.

The charged particle-optical device may comprise an array of detectors, referred to herein as an array of mirror detectors 350. The array of mirror detectors 350 is arranged along the primary beam paths 320 (e.g. at a common position along the primary beam path). The array of mirror detectors 350 is configured to face up-beam of the primary beam paths 320. In other words, the array of mirror detectors 350 is configured to face along the primary beam path 320 towards a source of the primary beam (described above as source 201). The array of mirror detectors 350 is configured to face away from the sample 208. The array of mirror detectors 350 may otherwise be referred to as an upwards array of detectors. Preferably, the array of mirror detectors 350 is associated with the lower electrode 243, and preferably an up-beam surface of the electrode. This may be beneficial as the signal particles may be more likely to be detected if the array of mirror detectors 350 are provided relatively close to the sample 208, e.g. just above or on the lower electrode 343. When the array of mirror detectors 350 is positioned within the objective lens array 241 (i.e. between electrodes of the objective lens array 241) it may be referred to as an in-lens detector. In an arrangement of an objective lens array assembly with multiple lensing electrodes, other electrodes may feature a mirror electrode, so long as another electrode is located up beam of the mirror electrode to mirror the signal particles towards the mirror electrode. If a detector is used as a mirror detector 350, then it would be understood that a main surface of the detector assembly (which may be described as the lowest or most down-beam surface in other embodiments with the detector facing down-beam) would be the highest or most up-beam surface when part of the mirror detector 350.

The charged particle-optical device may comprise at least one up-beam array of detectors facing towards the sample, i.e. in the direction of the sample 208. In other words, the up-beam array of detectors may be facing in a direction along the primary beam path 320 towards the sample 208. The charged particle-optical device may comprise upper array of detectors 370. The upper array of detectors 370 may be associated with the down-beam surface of the upper electrode 242 of the objective lens array 241. More generally, the upper array of detectors 370 could be associated with a down-beam surface of any appropriate electrode if more electrodes are provided in the objective lens array. The upper array of detectors 370 may be positioned between the upper electrode 342 and the lower electrode 343, or between any other electrodes above the lowest electrode of the objective lens array. As described above, the upper array of detectors 370 is provided up-beam (in relation to the primary sub-beams 211 and 212) of at least one electrode, which is the lower electrode 243 in relation to **FIG. 8****.** Additionally or alternatively, the charged particle-optical device may comprise an above-lens array of detectors 380. In other words, the up-beam array of detectors may be above the objective lens array 241. The above-lens array of detectors 380 may be up-beam of all the electrodes forming the objective lens array 241. The above-lens array of detectors 380 may be spaced apart from the electrode 242 so that the above-lens detector array 380 is a plate or substrate with its own mechanical support separate from the objective lens array. A Wien filter array may additionally be used to direct the signal particles towards detectors located between the sub-beams (e.g. when in the above-lens detector array), or the signal particles may be directed to a detector array positioned outside of the primary sub-beam paths.

Any of the detector arrays may be associated with (e.g. in, on, positioned adjacent to, connected to, or integrated with) at least one electrode of the objective lens array 241 (e.g. either the upper electrode 242 or the lower electrode 243). For example, the array of detectors may be in or on at least one electrode of the objective lens array 241. For example, the array of detectors may be positioned adjacent to one of the electrodes. In other words, the array of detectors may be positioned in close proximity and next to one of the electrodes. For example, the array of detectors may be connected (e.g. mechanically connected) to one of the electrodes. In other words, the array of detectors may be attached to one of the electrodes, e.g. by adhesive or welding or some other attachment method. For example, the array of detectors may be integrated with the one of the electrodes. In other words, the array of mirror detectors may be formed as part of one of the electrodes.

Combinations of the detector arrays may be provided. For example, the down-beam array of detectors 240 and/or the array of mirror detectors 350 and/or the upper array of detectors 370 and/or the above-lens array of detectors 380 may be provided. The device may comprise an additional array of detectors which may be provided with any combination of the down-beam array of detectors 240 and/or the array of mirror detectors 350 and/or the upper array of detectors 370 and/or the above-lens array of detectors 380. As will be clear from the above described combinations of arrays, there could be any appropriate number of detector arrays. For example, there could be two, or three, or four, or five, or more arrays of detectors which are positioned at any appropriate place, for example, as described above in relation to the up-beam array of detectors and/or the down-beam array of detectors. Whichever detector arrays are provided may be used simultaneously. A potential of any of the detector arrays (e.g. the array of mirror detectors 350 and/or the upper array of detectors 370 and/or the above-lens array of detectors 380 and/or the down-beam array of detectors 360 and/or any additional array of detectors) relative to a potential of the sample 208 may be selected to control detection of the signal particles at least that detector array. The array of sub-beams (otherwise referred to as an array of primary beams) may correspond with any/all detector arrays provided. Thus, the array of sub-beams may correspond with the array of mirror detectors 240, and/or the down-beam array of detectors 360, and/or the upper array of detectors 370 and/or above-lens array of detectors 380. Thus, any/all of the detector arrays may be aligned with the sub-beams.

**FIG. 10** is a schematic diagram of an exemplary single beam charged particle beam tool 40 according to an embodiment. As shown in **FIG. 10****,** in an embodiment the charged particle beam tool 40 comprises a sample holder 207 supported by a motorized stage 209 to hold a sample 208 to be inspected. The charged particle beam tool 40comprises an charged particle source 201. The charged particle beam tool 40 further comprises a gun aperture 122, a beam limit aperture 125 (or beam limiter), a condenser lens 126, a column aperture 135, an objective lens assembly 132, and a charged particle detector 144 (which may otherwise be referred to as an electron detector). The objective lens assembly 132, in some embodiments, may be a modified swing objective retarding immersion lens (SORIL), which includes a pole piece 132a, a control electrode 132b, a deflector 132c, and an exciting coil 132d. The control electrode 132b has an aperture formed in it for the passage of the charged particle beam. The control electrode 132b forms the surface facing the sample 208. Although the charged particle beam tool 40 shown in **FIG. 10** is a single beam system, in an embodiment a multi-beam system is provided. Such a multi-beam system may have the same features as shown in **FIG. 10****,** such as the objective lens assembly 132. Such a multi-beam system may have in addition beam limiter array, for example down-beam of the condenser lens, for generating the sub-beams. Associated with the beam limiter array, such as down beam of the beam limiter array, may be a number of charged particle array elements such a deflector array and a lens array for optimizing and adjusting the sub-beams and reducing aberrations of the sub-beams. Such a multi-beam system may have a secondary column for detecting signal charged particles. A Wien filter may be up-beam of the objective lens assembly to direct the signal particles towards a detector in the secondary column.

In an imaging process, a charged particle beam emanating from the source 201 may pass through the gun aperture 122, the beam limit aperture 125, the condenser lens 126, and be focused into a probe spot by the modified SORIL lens and then impinge onto the surface of sample 208. The probe spot may be scanned across the surface of the sample 208 by the deflector 132c or other deflectors in the SORIL lens. Signal particles emanated from the sample surface may be collected by the charged particle detector 144 to form an image of an area of interest on the sample 208. The condenser and illumination optics of the charged particle beam tool 40 may comprise or be supplemented by electromagnetic quadrupole charged particle lenses. For example, as shown in **FIG. 10** the charged particle beam tool 40 may comprise a first quadrupole lens 148 and a second quadrupole lens 158. In an embodiment, the quadrupole lenses are used for controlling the charged particle beam. For example, first quadrupole lens 148 can be controlled to adjust the beam current and second quadrupole lens 158 can be controlled to adjust the beam spot size and beam shape.

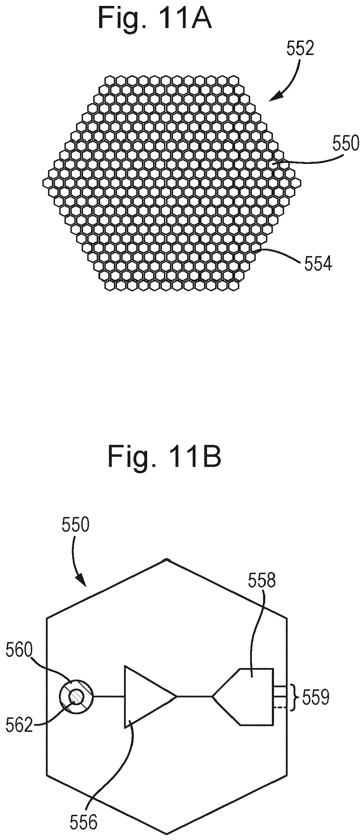

As shown in **FIG. 11A** a surface of a detector array or detector module (preferably facing, even proximate in use to, a sample) features an array of detector elements (or an array of detectors). Each detector element is associated with an aperture. Each detector element is associated with an assigned surface area of the substrate of the detector module . As the substrate is layered, for example in having a CMOS structure, each layer within the substrate is positioned with respect to the respective detector elements, preferably proximately. Commercially available CMOS structures have a usual range of layers, for example three to ten, usually about five. (For example, two functional layers may be provided for ease of description, which may be referred to as circuitry layers. These two layers of wiring layer and logic layer may represent as many layers as required and each layer is not restricted to wiring or logic, respectively.) The number of layers is limited by commercial availability and any number of layers is feasible. However, in view of practicality, the substrate has a limited number of layers, in order for an efficient design the available space is limited.

Ideally a circuit layer of the substrate, which can be the wiring layer and/or logic layer, has a portion assigned for each detector element (or detector). The assigned portions of the different layers may be referred to as a cell 550. The arrangement of portions in the substrate for the full multi-beam arrangement may be referred to as a cell array 552. The cells 550 may be same shape as the surface area assigned for each detector element, such as hexagonal, or any reasonable shape that may tesselate and may all be similar in shape and/or area, such as a rectangular shape. Having a rectangular or rectilinear shape can more readily be used by placing and routing design. Such design is commonly implemented by software that is suited to define chips with an rectangular type architecture with orthogonal directions, than architecture requiring acute or obtuse angles such as in a hexagonal architecture. In **FIG. 11A** the cells 550 are depicted as being hexagonal and the cell array 552 is depicted as a hexagon comprising individual cells. However, ideally each similarly located with respect to detector elements. Wiring routes 554 may connect to each cell 550. The wiring routes 554 may be routed between other cells of the cell array 552. Note: reference to wiring routes to be between cells of the array, it is intended that at least the wiring routes avoid the beam apertures of the array of apertures, e.g. defined through the cell array. In an arrangement circuit architecture, the cell size in at least the circuit layer may be reduced to accommodate the wiring routes, so that the wiring routes are routed between cells. Additionally or alternatively the wiring routes pass through the cells of the cell array, preferably towards the perimeter of the cells for example to reduce the interference of the wiring routes with other circuitry in the cells. Therefore reference to a wiring route between the cells encompasses: a wiring route between the circuitry of cells, a wiring route within cells, preferably towards the periphery of the cells and at least around the beam apertures through the cells and any intermediate variation. In all these arrangements, for example in a CMOS architecture, the wiring routes may be in the same die as the other circuitry which may define circuitry in the same cell as a portion of the wiring route, or circuitry in a cell around which the wiring route is routed. Thus, the cells and wiring routes may parts of a monolithic structure. The wiring routes 554 may signally connect the cells. Thus the wiring routes signally connect the cells 550 to a controller or data processor external to the cell array or even the substrate or detector module. The circuit layer may comprise a datapath layer for the transmission of sensor signals from a cell outward of the cell array.

The controller or data processor may before circuitry within the substrate or detector module, preferably external to the cell array for example as control and I/O circuitry (not shown). The control and I/O circuitry may be in the same die as the cell array; the control and I/O circuitry may be monolithically integrated with the cell array, for example in the same CMOS chip. The control and to I/O circuitry enables an efficient connection between the data from all the cells of the cell array 552. Consider for example an arrangement of 2791 cells each having an 8 bit digital output. Such an arrangement would have 22328 signals (i.e. 8 bit output *2791cells) to the electronics located outside the CMOS chip. The standard way of doing this is to use a SERDES circuitry (serializer / deserializer). Such circuitry would transform a large number of low data rate signals into a few number of high data rate signals by means of time division multiplexing. It is therefore beneficial to have control and I/O circuitry monolithically with the cell array, or at least in the detector module, than external to the detector module.

In embodiments the control and I/O circuitry may feature general supporting functions, such as circuitry to communicate with the electronics outside the CMOS chip to enable loading certain settings, for example for control of amplification and offset such as subtraction as described herein.

The circuit layer of a cell 550 is connected to a detector element of the respective cell. The circuit layer comprises circuitry having amplification and/ digitation functions, e.g. it may comprise a amplification circuit. A cell 550 may comprise a trans impedance amplifier (TIA) 556 and an analogue to digital converter (ADC) 558 as depicted in **FIG. 11B****.** This figure schematically depicts a cell 550 with an associated detector element such as capture electrode and a feedback resistor 562 connected to the trans impedance amplifier 556 and the analogue to digital converter 558. The digital signal lines 559 from the analogue to digital converter 558 leave the cell 550. Note that the detector element is represented as a detector element 560 and feedback resistor is shown associated with the detector area as a disc 562 rather than associated with the trans impedance amplifier 556. This schematic representation is to represent each of the detector element and the feedback resistor as an area to indicate their relative size.

The trans impedance amplifier may comprise a feedback resistor Rf 562. The magnitude of the feedback resistor Rf should be optimized. The larger the value of this feedback resistor, the lower the input referred current noise. Thus the better signal-to noise ratio at the output of the transimpedance amplifier. However, the larger the resistance, Rf, the lower the bandwidth. A finite bandwidth results in a finite rise and fall time of the signal, resulting in additional image blur. An optimized Rf results in a good balance between noise level and additional image blur.

To implement the design the circuitry i.e. the amplification circuitry associated with each detector element should be within the layers of the associated cell 550 and fit in the limited area available of the portions of each associated layer. In the case of a sub-beam pitch of 70 micron, the available area per layer in the cell is typically only 4000 square micron. Depending on the sensed secondary and/or backscatter signal particles, for example as current to be measured by the detector element, the optimum value for the feedback resistor Rf can be as high as 30 to 300MOhm. If such a resistor would be implemented as a poly resistor in a standard CMOS process the size of such resistor would be much larger than the area that is available in the CMOS layers of the cell 550. For example, a resistor of 300MOhm would consume around 500000 micron^2. This is about 130 times larger than the entire available area.

Typically, for example in CMOS architecture, such a large resistor would be made in a single layer for example of polysilicon. Usually there is a single layer of polysilicon. In some circumstances a layer could be provided having material capable of providing high resistor values, although with such a high aspect ratio (e.g. extreme length relative to width of the resistive structure in the layer) the reliability of the resistor remains. Even if the cell were to have multiple layers used for such a resistor, many more layers would have to be present that is readily available for example using CMOS technology. Additionally or alternatively, the meandering path through different layers would not mitigate the high aspect ratio and risk of variation in the resistance value would only be contributed by the interconnections between different layers. Such interconnects influence the variability of the resistance value of a resistor as a corner, as later described herein.

Note that such dimensions are calculated assuming a 180 nm node architecture and processing. If alternatively a smaller processing node is used, it is unlikely that a factor of thousand in reducing the dimensions of the resistor structure could be gained. Further, using 180 node architecture is preferred to a smaller node for processing reasons. For instance interconnects in a 180 nm node are simpler to process. Post processing of a detector chip for example in etching the beam apertures 504 uses aluminum interconnects. Such post processing at a sub-180nm node typically uses a process with Copper interconnects. Processing at 180 nm is therefore simpler than at sub-180 nm.

Further if such a resistor were made, in whichever node, the reliability of the resistor specifications as well as the space available for the resistor may be challenging.

In a layered structure for chip architecture, such as CMOS, the components and features are defined as structures in a layer. The specification of a component is dependent on the material of the layer and the physical properties of the layer, the dimensions of the layer, specifically its thickness and the dimensions of the structure formed in the layer. A resistor may take the form of a long narrow path, route or wire. In view of space constraints, the path may be non-linear, having corners along its path. For such a long component, the width of the path in the layer may vary such as through manufacturing tolerances. A corner may provide greater variance than a linear section of the path, limiting the accuracy with which the resistor can be made in order to have a specified resistance. With many corners and a long length, a resistor having such topology may made with poor reliability so that the resistances for equivalent resistors in different cells of the cell array may have a large range.

Such a resistive structure has a large surface area. Additionally or alternatively, a resistor with such a large surface area would additionally have a capacitance which is undesirable; such a capacitance is referred to as a parasitic capacitance. Parasitic capacitances may undesirably contribute to noise and blur, influencing the balance between noise, blur and bandwidth optimization which is elsewhere herein described

The material properties of the layer can be modified chemically; however such modifications are unlikely to achieve the improvement of several orders of magnitude in size to fit into available space in the cell. Such modifications are unlikely to change the topography of the feedback resistor sufficiently so that has the required specification and can be made with the desired reliable accuracy.

Such requirements in reliability and size would enable the resistor to achieve its desired performance in terms of bandwidth, signal to noise ratio, and stability. Unfortunately these requirements cannot be met.

Alternative amplification circuitry is proposed which does not require such a large feedback resistor. Examples include a trans impedance amplifier with a pseudo resistor as a feedback element and a direct analogue to digital converter, obviating the need for a transimpedance amplifier. Two examples of a direct analogue to digital converter are: using a low duty cycled switched resistor, and using a reference capacitor. These examples are described in detail in ,European Application No. 20217152.6 filed on 23 December 2020 which is hereby incorporated by reference, particularly in relation to the use of a low duty cycled switched resistor and a reference capacitor. An optional arrangement is to remove the analogue to digital converter 558 from the cells 550 so that a circuit wire 570 connects the trans impedance amplifier 556 in the cell 550 with the analogue to digital converter external to the cell array 552, as described in European Application No. 20217152.6 filed on 23 December 2020. By removing the analogue to digital converter from the cell 550, there is more space available in the circuit layer of the cell 550 for a feedback resistor element. There is yet more space in the circuit layer of the cell 550 if the amplifier circuitry uses an alternative trans impedance amplifier circuit, for example if a trans impedance amplifier with a pseudo resistor is used as a feedback element. The example amplifier circuits described are just some of the suitable types of amplification circuitry that can be used. Other amplifier circuits may exist which achieve similar benefits to those described herein and which use similar circuit architecture for each cell as herein described.

Although it may be easier to fit the trans impedance amplifier 556 with a pseudo resistor feedback element and analogue to digital converter in the circuit layers of the cell, in an arrangement it is more practical for space constraints for the analogue to digital converter 558 to be external to the cell array 552. This is despite the use of a pseudo resistor in the feedback element of the trans impedance amplifier providing a gain of one to two orders of magnitude in area. One consideration to decide whether or not the analogue to digital converter 558 is external to the cell array 552 is the sub-beam pitch of the multi-beam. For example with a sub-beam pitch of 70 micron, typically only 4000 square micron is available per layer of a cell for the circuitry including the amplification circuitry.

Under such space constraints, a trans impedance amplifier is located in the cell of each beam. The analogue to digital converter is located outside the array of sub-beams, i.e. outside the cell array. In an embodiment, the analogue to digital converter is present on the same die as the cell array, for example monolithically with the cell array. Such an analogue to digital converter may be located with the control and I/O circuitry which may be on the detector module or even monolithic with the cell array 552. Locating the analogue to digital converter external to the cell array may provide an area gain of about a factor of two.

The circuit wire 570 connects the trans impedance amplifier in a cell 550 with the associated analogue to digital converter 558. The circuit wire 570 transmits an analogue signal. Unlike a digital signal, a data path transmitting an analogue signal is susceptible to interference. Signal interference can be from cross-talk with other circuit wires and from external fields such as generated by the sub-beams of the multi-beam and fields from nearby charged particle optical components such as the objective lens array 241.

The circuit wire 570 is routed through the a wiring route 554 as depicted in **FIG. 11A****.** The wiring route 554 is routed between cells so that the area of a cell and its layers is used for the amplification circuitry present on a cell. The wiring route 554 therefore only uses a portion of the circuit layers in which the wiring route is present, namely between adjoining cells 550 (e.g.. at least around the beam apertures 504, 406 of the adjoining cells 550; through the adjoining cells 550 such as towards the periphery of the cells or between the circuitry in a layer assigned to the adjoining cells 550, or any arrangement between the stated arrangements). This routing avoids architectural interference of the amplification circuitry and the architecture of the wiring routes 554. Circuit wires are routed along the wiring routes in the cell array in an outward direction, for example in a radially outward direction. With greater proximity to a perimeter of the cell array 552, there may be more circuit wires 570 than in a portion of the wiring route 554 remote from the perimeter. The wiring route may have a plurality of circuit wires 570, which as described, is between cells of the array. Therefore a portion of the wiring route 554 may have more than one circuit wire 570. However, having circuit wires located close to each other risks crosstalk between the circuit wires and interference of the analogue signals transmitted by the circuit wires 570.

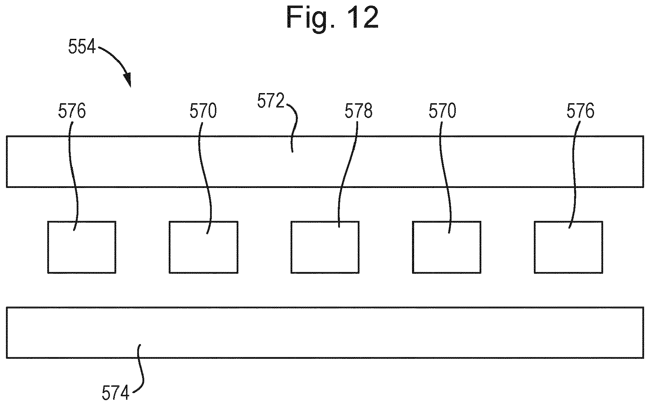

The risk of crosstalk and signal interference may be at least reduced or even prevented by having the circuit wires 570 shielded from each other within the wiring route. **FIG. 12** depicts cross-section of an exemplary arrangement of wiring route 554. Within the wiring route 554 are one or more circuit wires 470, shown extending in same direction as the wiring route 554 and a shielding arrangement. The circuit wires are shown in the same layer. Above the circuit wires 570 is an upper shielding layer 572; beneath the circuit wires 570 is a lower shielding layer 574 (or more down-beam shielding layer 574). The upper and lower shielding layers of the shielding arrangement shield the circuit wires 570 from fields external to the wiring route 554 above and beneath the wiring route 554. The shielding arrangement has shielding elements in the same layer as the circuit wires 570. The shielding elements may be outer elements 576 at the outer edges of the layer comprising the circuit wires 570. The outer elements 576 shield the circuit wires 570 from fields external to the wiring route 554. The shielding elements may include intermediate shielding elements 578 that are present in the layer between adjoining circuit wires. The intermediate shielding elements 578 may therefore at least suppress if not prevent cross-talk between the circuit wires 570. In operation, a common potential is applied to the shielding layers 572, 574 and shielding elements 576, 578. The potential may be a reference potential for example a ground potential.

Although **FIG. 12** depicts a three layer arrangement, as many layers may be used in the wiring route 570 as may be desired. For example, there may be two layers of circuit wires, requiring three shielding layers which include an upper shielding layer 572, a lower shielding layer 574 and an intermediate shielding layer. The intermediate shielding layer may additionally reduce if not prevent crosstalk between the circuit wires in the different layers of the wiring route 570. Thus, there are five layers in total. Every additional layer of circuit wires requires an additional intermediate shielding layer. Whereas increasing the number of layers in the wiring route 554 reduces the proportion of a layer that wire routing requires, such a variation in design requires additional layers. In view of the limited number of layers, there is an optimum number of layers at which the width of the wiring route is reduced without exceeding the number of layers required elsewhere in the substrate of the detector module, which can be limited to five layers.

A further consideration of the design of wiring route is the number of circuit wires that may need to be present in an exemplary design of detector module, for example consider the arrangement of **FIG. 12** with all circuit wires 570 in a layer.

For example, an array of sub-beams is arranged an hexagonal array with thirty (30) rings of sub-beams, for example arranged concentrically. The detector module therefore has a cell array of corresponding design. The number of cells is around 3000, for example 2791. Such a cell array may have a pitch of seventy (70) micron

The outermost ring has the highest number of signals that need to be routed through the ring. Considering the wiring route is routed between cells of the cell array, all the signals of the cells are routed through the outermost ring, between the cells of the outermost ring. In this example the outermost ring consists of 180 cells, so the number of signals transported through the outermost ring, e.g. between the cells of the outermost ring, is approximately 2600 (i.e. 2611). Thus, the maximum number of signals to be routed through the outer ring between adjacent cells is the total number of signals (2611) divided by the number of cells in the outermost ring (180). This is fifteen 15 (rounded up to the nearest whole number). Since the wiring route has a shielding arrangement to ensure that the signals are well shielded, e.g. limiting crosstalk and the influence of external fields, there may be sixteen shielding elements, including fourteen (14) intermediate shielding elements and two outer shielding elements 576. Therefore between adjacent cells 550 of the outer ring of the example, a wiring route having all circuit wires in the same layer would have thirty-one (31) elements of alternate shielding elements and circuit wires.

For cell array 552 for a beam array with a pitch of 70 microns, there is enough space, or area, available in the circuit layer, for such a wiring route 554. In a structure created using a process at the 180nm node, the minimum half pitch of a metal layer is typically around 280nm. In this context a half pitch is a line and a pitch is the line with an associated gap with an adjoining gap. The associated gap is typically the same width the line. The wiring route for thirty-one elements requires thirty-one pitches. However, the associated gap of one of the elements, that corresponds to the outer elements 576, is not part of the wiring route 554, but would separate the wiring route from adjoining circuitry. Therefore, for thirty one elements, sixty-one (61) half pitches are required, which corresponds to a width of the circuit wiring 554 of approximately 17.1 micrometers.

In a different arrangement, the beam array may be hexagonal having 108 rings and around 35000 cells, and may be considered to be a monolithic beam array. The outermost ring has around 650 cells. Around 34350 signals are required to be routed through the outermost ring. So around 54 signals need to be routed through adjoining cells in the outermost ring. A wiring route 554 having 54 circuit wires 570 has 55 shielding elements. Applying a similar calculation as for the previous example in applying this architecture to a half pitch of 280nm, the width of the circuit wire would be under 61 micrometers. This size would fit between the cells 550 of the outermost ring. In an alternative arrangement the beam arrangement is apportioned in to two or more strips with one or more intermediate strip for routing a support structure, cooling features such as conduits, data transmission lines and the like. Such a beam array may be referred to as a stripped beam array. The wiring routes may therefore be routed through the one or more intermediate strips. This enables a larger beam array, thus cell array yet maintaining a reasonably sized wiring route. If a stripped beam array were to have the same number of sub-beams as a monolithic beam array, the wiring routes would have fewer circuit wires 570 than the monolithic cell array i.e. fewer than 54. Indeed a stripped beam array may achieve a larger number of sub-beams than a monolithic beam array because the size of the beam array, as limited by the maximum number of circuit wires that may be in the wiring route, would be larger

The optimization of the noise performance for example in terms of bandwidth and noise optimization and balance between the blur and the noise can be enabled by making sure an amplification factor of the trans impedance amplifier is programmable. In a such an arrangement, the amplifier circuit of the cell, at least the trans impedance amplifier, is programmable. Such a programmable amplification circuit may comprise a variable amplifier and/or a variable analogue to digital converter for example, in terms of its sensitivity.. The variable amplifier has a variable amplification range dependent on a detected beam current detected by a detector element503. For example, when the detected beam current is low, or for a sample with a lower than typical secondary emission coefficient, the variable amplifier can be adjusted to provide a larger amplification than normally used. When a larger beam current than normal is detected by a detector element 503, or for a sample with a larger than typical secondary emission coefficient, the variable amplifier can be tuned to provide a smaller amplification.

This functionality is beneficial with a trans impedance amplifier with a feedback element having pseudo resistor. A pseudo resistor has different effective resistances on application of different applied voltages; unlike an ideal resistor which has a single resistance at all applied potential differences. In providing different resistance, the trans impedance amplifier associated with the pseudo resistor operates as a variable amplification. In providing an amplifier with variable functionality, an optimized balance between noise levels and image blur (referred to herein above as 'additional blur') may be achieved. Beneficially, the programmable amplification circuit may match the output of the trans impedance amplifier with the input of the analogue to digital converter. This may be as a programmable offset that is subtracted between the output of the trans impedance amplifier, and the input of the analogue to digital converter. The programmable offset may help reduce the required number of bits that need to be transmitted from the amplification circuit of a cell. The programmable offset may be implemented in the programmable amplifier. These measures help to ensure that the dynamic range of the trans impedance amplifier and the analogue to digital converter, and thus preferably the amplification circuit, are optimally used for different use cases. Such different use cases may include: the material properties of a sample under inspection, different assessment tool configurations for example using different beam currents. The range of applications may be enabled by the provision of a variable amplifier and a variable off set or threshold (e.g. subtraction by a programmable offset) desirable enables tuning of amplification, threshold and bandwidth As mentioned elsewhere herein, the circuitry associated with variable amplification and subtraction may be comprised in the control and I/O circuitry.

Known detector assemblies may suffer from contamination, e.g. hydrocarbon (CxHy) contamination, especially in cases where the assemblies are used to inspect an object comprising resist, such as covered in resist, e.g. for after develop inspection (ADI) of a substrate/wafer. That is the resist is developed after exposure and then inspected. Molecular carbon contamination will grow on surfaces that are in a vacuum atmosphere with a high partial pressure of hydrocarbons in combination with exposure by electrons. The contaminating carbon may originate, for example, from a carbon source on the sample, such as the resist. This process is known as electron beam induced deposition (EBID). A critical component of an assessment apparatus may be the detector assembly, particularly when the detector assembly is positioned proximate to the sample because the presence of resist may increase the amount of contamination in the detector when in this position.

As described above, depending on the configuration used, the pressure in the main chamber may be deeper than 10⁻⁶ mbar. In an arrangement during assessment, the pressure between substrate and facing surface of the electron-optical device, e.g. detector, may be higher for example approximately 10⁻⁶ mbar or even 10⁻⁵ to 10⁻⁴ mbar. For both after etch inspection and after development inspection (which is inspection before removal of the resist), there is a pressure rise due to electron induced outgassing (also known as electron stimulated desorption). However, the composition of the gas will be different. In after etch inspection, the main outgassing is H₂O. Possibly, this can be lowered by pre-flooding the sample using a flood column. In after development inspection, a substantial part of the outgassing (10% to 50%) is CₓH_{y} which can cause contamination (i.e. as electron beam induced deposition).

In order to be sensitive enough to detect signal particles emitted from a sample, detector assemblies which are used for assessment of the sample should be able to detect very small currents. This means that the resistivity between a detection electrode and its surroundings should be high enough to avoid significant leak currents which may prevent the detector assembly (e.g. the electronics such as an amplifier in the detector assembly) from working.

For example, a detector assembly may ideally be able to detect a current as low as 100 pA. A typical trans impedance amplifier will have a variation at the input of roughly 50 mV because of finite loop gain of the amplifier. Thus, in order to have a leak current significantly lower than 100pA the resistivity between detection electrode and surroundings must be as high as 5 GΩ. The resistivity between the detection electrode and its surroundings will be affected by any electron beam induced deposition between the detection electrode and its surroundings, especially if the isolation between a detector and an adjacent electrically conductive element such as another detector element is small. Thus, it is beneficial to avoid or at least reduce such deposition.

If such electron beam induced deposition forms between the detection electrode and its surroundings this will short the detection electrode such that it is no longer sensitive enough to detect signal particles emitted from the sample. Such a short could be caused by contamination forming to bridge the isolation of the detector electrode, for example, from another conducting element such as another detector electrode. For example, if electron beam induced deposition forms on the substrate 404 in the gap between detector electrodes 405 as shown in **FIG. 7****,** the electron beam induced deposition may build up to bridge the isolation between the detector electrodes 405. Thus, adjacent detector electrodes 405 may be connected to each other by the contamination, meaning that adjacent detector electrodes 405 are no longer isolated from each other. The same issue will arise when the detector electrodes 405 are differently arranged.

Reducing or avoiding such deposition can significantly improve the lifetime of the detector assembly. Additionally, reducing or avoiding such deposition reduces the need for cleaning of the detector and therefore, can reduce the amount of downtime for the detector assembly.

In the present invention, the deposition is reduced by providing a recess in a main surface of a detector assembly between a detection electrode and its surroundings. This is beneficial for reducing or avoiding the build-up of deposition between a detector element and its surroundings which may otherwise affect the sensitivity of the detection element. Preferably, a surface of the detector assembly is recessed so as to be out of the line of sight of electrons.

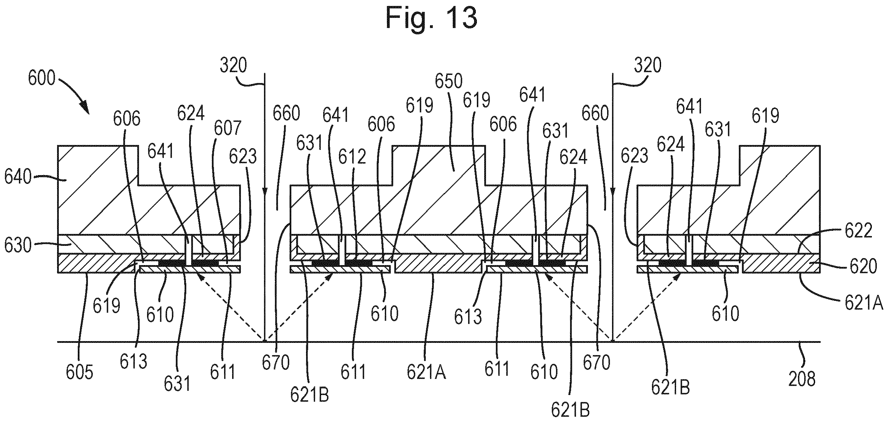

An exemplary version of such a detector assembly is shown in **FIG. 13** which is described in detail below. **Fig. 13** shows a cross section through the detector assembly. The detector assembly 600 may be used as detector array 240, for example as shown in **FIGS. 2-9****,** or as a charged particle detector 144 as shown in **FIG. 10****.** The detector assembly may be used for a charged particle assessment apparatus, although the detector assembly can be provided without other components.

The detector assembly 600 may comprise detection elements 610 configured to detect signal particles. Any appropriate types of detector may be used for the detection element 610 as described in further detail below. The detection elements 610 may correspond to detector elements 405 as described in any of the variations above. At least one, multiple, or all the detection elements 610 may comprise multiple portions (i.e. may be a zoned detector element), e.g. as described above in relation to **FIGS. 6A** and **6B****.** A detector element 610 may be in the form of one or two or more layers. The layers or at least the surface is preferably metal. Any appropriate metal may be used, e.g. aluminum, copper, etc..

The detector assembly 600 may comprise shield elements 620 for shielding elements within the detector assembly 600. Each shield element 620 may have a surface that is stepped relative to the beam path which may be in the form of one or two or more layers. The layers or at least the surface is preferably metal. Any appropriate metal may be used, e.g. aluminum, copper, etc.. Although multiple shield elements 620 and detection elements 610 are shown in **FIG. 13** and described herein, only a single shield element 620 and a single detection element 610 may be provided.

The shield element 620 is beneficial (particularly at the level of surface 622) in preventing capacitive coupling between the circuitry and the detection electrode. Thus, the shield element 620 shields "other components of the detector assembly" from the detection electrode. At the location of the shield element 620 as shown in **FIG 13****,** signal charged particles originating from both beams either side of the shield element 620 will arrive on the surface. Signal electrons originating from adjoining beams will reach the major surface 621A. To help prevent cross talk, the part of the main surface of the detector assembly which is used for the shield element 620 as shown in **FIG. 13** is not used for detection, as this helps prevent cross talk of signal particles being detected by adjacent detectors. Thus, another purpose of the shield element 620 is to limit cross talk when the shield element 620 is present at, or provides part of, the main surface of the detector assembly, which may be the most lowest or downbeam surface.

The detection elements 610 each have a major surface 611 which may be configured to be exposed to signal particles (shown by dashed arrows) emitted from the sample 208. The major surface 611 may be the first surface contacted by the signal particles. The major surface 611 of the detection elements interacts with signal particles and through which signal particles can be detected by the detection element 610. The major surface 611 of the detection element may be a detection surface. The major surface 611 of each of the detection elements 610 provides an outer (i.e. outwardly facing) surface of each detection element 610. Each detection element 610 also has an inner surface 612 facing an opposing direction to the major surface 611 (i.e. the outer surface).

The shield elements 620 each have an outer (i.e. outwardly facing) surface 621. The outer surface 621 may provide a major surface 621A and a cavity surface 621B. The shield elements 620 each have a major surface 621A which may be configured to be exposed to signal particles emitted from the sample 208. The cavity surface 621B may be set back relative to the major surface. The cavity surface 621B may at least in part define a recessed surface. The cavity surface 621B shown as being behind the detection element 610 in **FIG. 13** for example with respect to a signal particle from the sample 208. The major surface 621A of the shield element 620 may be the first surface contacted by the signal particles. At least part of the outer surface 621 of the shield element 620 interacts with signal particles and can be considered to prevent the signal particles from passing through the shield element 620 to other components of detector assembly 600. The major surface 621A of each of the shield elements 620 provides an outwardly facing surface of each shield element 620, e.g. which might face the sample support. The major surface 621A of the shield element 620 helps to limit cross talk. Each shield element 620 also has an inner surface 622 facing an opposing direction to the outer surface 621. Preferably, the inner surface 622 faces and is in contact with other elements of the detector arrangement, such as an isolating element 630 as shown in the arrangement shown in **FIG. 13****,** and/or a circuit layer.

The electrode elements, i.e. the detection elements 610 and the shield elements 620, may be arranged in a two-dimensional array. In particular, the major surfaces of the electrode elements may be arranged in a two-dimensional array. The two-dimensional array may be facing towards the sample support. The two-dimensional array may be formed in a plane which may be visible in plan view, i.e. which is substantially orthogonal to the sub-beams.

Preferably, the electrode elements, i.e. the detection elements 610 and the shield elements 620, are part of, or within, the structure of the detector assembly, which is preferably a planar detector assembly structure.

The major surfaces of the electrode elements may be configured to face towards the sample support configured to support the sample 208 (e.g. the sample holder 207). Preferably the major surface 621A of the shield element 620 provides at least part of a facing surface of the detector assembly 600 for facing the sample 208. As shown in **FIG. 13****,** the major surfaces 611 of the detection elements 610 and the major surfaces 621A of the shield elements 620 may face in the direction of the sample 208 (although this is not a necessity, for example in a mirror array as described above in relation to **FIG. 8**). The major surfaces 611 of the detection elements 610 and the major surfaces 621A of the shield elements 620 may directly face the sample, i.e. may be adjacent to the surface of the sample 208.

The major surfaces 611 of the detection elements 610 and the major surfaces 621A of the shield elements 620 may be planar surfaces. Preferably the major surfaces 621A of the shield element 620 are coplanar with the major surfaces 611 of the detection elements 610. In other words, the major surfaces 611 of the detection elements 610 and the major surfaces 621A of the shield elements 620 may be provided in a single plane. The major surfaces 611 of the detection elements 610 and the major surfaces 621A of the shield elements 620 may be provided as a two-dimensional array. At least part of the shield element may positioned between adjacent detection elements 610. For example, at least the major surface 621A of a shield element 620 may be provided between adjacent detection elements 610, as shown in **FIG. 13****.** In other words, at least part of a shield element 620 may be positioned in-between detection elements 610. Differing arrangements are possible, for example, as described in relation to the further figures below.

As shown in **FIG. 13****,** the major surfaces 611 of the detection elements 610 and the major surfaces 621A of the shield elements 620 are preferably in a common main surface 605 of the detector assembly 600, or major surface of the detector assembly. Preferably, the main surface 605 of the detector assembly is a planar surface. Thus, the major surfaces 611, 621A may be in the same plane. The main surface 605 may be an outer surface of the detector assembly 600 through which charged particles are detected.

The detector assembly 600 may be positioned in the path of the charged particle beam(s). For example, the major surfaces of the electrode elements may be substantially orthogonal to the charged particle beam path 320. For example, the detector assembly 600 may be positioned such that the sub-beams pass through, or adjacent to, the electrode elements of the detector assembly 600.

Each detection element 610 may be provided adjacent to at least part of a shield element 620. Between one of the detection elements 610 and an adjacent shield element 620 is a recess 606. The recess 606 extends from the gap between adjacent electrode elements. An opening of the recess 606 in the major surface is defined between the adjacent electrode elements. The recess is recessed relative to the major surfaces 611, 621A of the electrode elements. The recess 606 therefore replaces the surface between adjacent electrodes of the major surface on which contamination may otherwise be deposited. The recess 606 provides a cavity in which the isolating surface may be positioned remote from the major surface, for example, within the substrate, e.g. so that observation from the sample of the isolating surface is occluded by other features of the detector assembly. The recess 606 in the present embodiment may be non-linear, in having a corner 619 along its length, further improving the effect of the cavity, so that the isolated surface is outside the straight-line path of a signal particle from the sample surface. The chances of a signal particle reaching the isolating surface is reduced compared to an isolating surface directly bridging two electrodes in the major surface.

The recess 606 is defined by a recessed surface. The recessed surface has constituent parts of the detector assembly, for example, of the shield element 620 and/or the detection element. The recessed surface may be defined by an inner surface of the detection element and a portion of the shield element which faces the inner surface of the detection element. A portion of the recessed surface may be a surface (which may be referred to as an isolating surface) of an isolating element. The isolating surface may be part of the recessed surface between the surfaces of the shield element 620 and the detection element. In other words, the recess 606 extends from the major surfaces 611, 621A into the detector assembly 600, i.e. away from the sample 208. The recess 606 extends laterally behind the detection element 610. Thus, the recess 606 extends behind the detection element 610 from the gap between adjacent electrode elements in the main surface 605 of the detector assembly 600. Preferably, the recessed surface is sufficiently far away from the gap between adjacent electrodes (through which contamination may arrive at the recess 606) for the build-up of contamination to be of low significance. The recess 606 extending laterally is beneficial in that the isolating surface may be positioned remote from the major surface, for example positioning the isolating surface out of the line of sight of sample charged particles. Having a lateral recess means that the isolated surface is not in the straight-line path of a signal particle from the sample surface. The recess 606 is beneficial in that even if there is some electron beam induced deposition, the deposition will build up in the recess and is less likely to bridge the gap between the detection element and the shield element, so the detection element 610 is less likely to be short circuited, for example over the isolating surface. That is, any build up deposition over the recessed surface within the recess is less likely to bridge the isolating surface, than an arrangement in which the recess is absent.

Preferably, the dimension of the recess in the lateral direction is equal to or preferably greater than a dimension of the recess in a direction substantially perpendicular to the lateral direction. Preferably, the dimension of the recessed surface 606 in the lateral direction is equal to or preferably greater than the gap between the electrode elements for that recess (e.g. a dimension of the opening of the recess 606). The dimension of the recessed surface 606 in the lateral direction may be at least the length of the gap. The dimension of the recessed surface 606 in the lateral direction may be at least twice the length of the gap, at least three times the length of the gap, at least four times the length of the gap, at least five times the length of the gap, at least six times the length of the gap, at least seven times the length of the gap, at least eight times the length of the gap, at least nine times the length of the gap, at least ten times the length of the gap, or greater than ten times the length of the gap. In the examples shown in the figures, the dimension in the lateral direction in **FIG. 13** is the length that the recessed surface 606 extends along the inner surface 612 of the detection element 610. Thus the isolating surface is sufficiently remote from the major surface, for example relative to the area of the opening, of the recess decreasing the chances of a shorting between the adjacent electrodes and of the isolating surface. Having a larger dimension in the lateral direction is beneficial because the isolator surface, which is already out of the line of sight of the electrons, is positioned further away from the gap. Having a laterally shaped recess help efficiently to position the isolating surface, within the planar design of detector, especially as a detector array.

Preferably the recess 606 is recessed around at least part of a perimeter 613 of each detection element 610. Thus, the recess 606 is preferably recessed around an outside edge and/or an inside edge of the detection element 610. The recess 606 may be recessed around the whole perimeter 613 of each detection element 610. Similarly, the recess 606 may be provided around part, or the whole, of a perimeter of other electrode elements, e.g. shield elements 620.

Preferably the recess 606 adjoins adjacent electrode elements. For example, preferably the recess 606 adjoins adjacent detection elements 610 and shield elements 620. In other words, the recess 606 may extend between an adjacent detection element 610 and a shield element 620. The recessed surface of the recess 606 may connect adjacent electrode elements. Thus, the recessed surface may connect one of the detection elements 610 to an adjacent shield element 620 (and/or to another detection element 610).

The recessed surface may be formed by several components. For example, part of a surface of the detection element 610 may form part of the recessed surface. For example, part of a surface of the shield element 620 may form part of the recessed surface. As shown in **FIG. 13****,** part of the inner surface 612 of the detection element 610 may be part of the recessed surface and/or part of the major surface 621A of the shield element 620 may be part of the recessed surface 606.

Preferably at least one shield element 620 comprises a layer preferably providing a facing surface of the detector assembly for facing a sample. Thus, at least part of the shield element 620 may provide a lower surface of the detector assembly positioned facing the sample and/or sample support.

It is noted that some, but not all, of the detection elements 610 and the shield elements 620 may have a recessed surface behind the respective electrode element. In particular, some of the shield elements 620 may not have a corresponding recessed surface. For example, as shown in FIG. 13, only the detection elements 610 have a recess 606 laterally extending behind them; these detection elements are the electrode elements supported by and connected by the portion of the isolating element 631, unlike the other electrode elements (e.g. the shield elements 620 which are supported by and connected to the isolating element 630).

A portion 624 of the shield element 620 may extend parallel to the major surface 611 of the detection element 610. The portion 624 of the shield element 620 being behind at last part of the detection element 610. Thus, the portion 624 of the shield element 620 may be positioned substantially parallel to the detection element 610. As in **FIG. 13****,** the shield element 620 may extend from between detection elements 610 to an inner edge of the detection assembly 600 (which is a passageway of an aperture as described below).

The detector assembly 600 may have a main body 650. The main body 650 may be formed as a substrate. Different component parts of the detector assembly 600 may be formed as layers of the substrate 650 for example using semiconductor fabrication processes, and/or may be attached together. At least part of a surface of the main body 650 of the detector assembly 600 may be part of the recessed surface

The detector assembly 600 may additionally comprise the isolating element 630. The isolating element 630 may be configured to support the electrode elements. The isolating element 630 may be configured to support at least the shield element 620. The shield element 620 may be positioned on the isolating element 630. At least part of the isolating element 630 may be configured to support the detection element 610. The detection element 610 may be positioned on the part of the isolating element 630. Preferably, the isolating element 630 is one or more layers. The isolating element 630 may be made of any appropriate material, e.g. SiO₂, which may optionally be doped or porous.

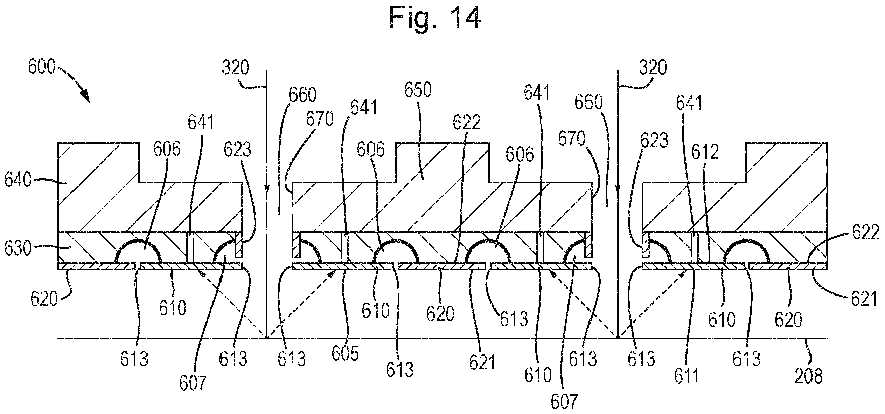

A portion 631 of the isolating element 630 may be positioned between the shield element 620 and the detection element 610. As shown in **FIG. 13****,** this may be a thin planar portion 631 of isolating element 630 which is substantially coplanar with the detection element 610 and/or the shield element 620. The isolating element 630 may be provided in other shapes (e.g. such as those shown in **FIG. 14** as described below). By placing the shield behind the detection electrode 610, e.g. as shown in **FIG. 13****,** a significant lateral recess can be realized without having a deep recess (in the direction of the beam path 320)

Part of a surface of the isolating element 630 is at least part of the recessed surface. As shown in **FIG. 13****,** a surface of the isolating element 630 positioned between the detection element 610 and the shield element 620 may form part of the recessed surface. Thus, the recess is at least partly defined by the isolating element 630. In the example shown in **FIG. 13****,** the recessed surface is provided by respective surfaces of the detection element 610, the isolation element 630 and the shield element 620. Thus, the recess can be formed by the isolating element 630, the detection element 610 and the shield element 620 is order to provide the recess (i.e. space) adjacent to the gap between the detection element 610 and the shield element 620. That is the recessed surface is defined by portions of surface of each of the detection element 610, the shield element 620 and the isolating element 630. So the constituent elements of the recessed surface may be the inner surface 612 of the detection element 610, the cavity surface 621B of the shield element and the isolating surface interconnecting the inner surface 612 and the cavity surface 621B. As previously described, this means that build-up of contamination on certain parts of the recessed surface, e.g. including the isolating surface of the isolated element 630, is slower. The risk of deposition of contamination on, for example the isolating surface, is of lower significance as it is less likely, if not unlikely, to connect adjacent electrode elements, for example the inner surface 612 and cavity surface 621B of the recessed surface.

The detector assembly 600 may comprise detector circuitry which may be connected to the detection element 610. The detector assembly 600 may comprise a circuitry layer 640 comprising detector circuitry which is in electrical communication with the detection element 610. The circuitry layer 640 may comprise some, if not all, of the circuitry used to process the signals from the detection elements 610. Thus, the circuitry layer 640 may convert the detected signal particles into electrical signals. The circuitry layer 640 may comprise various different electrical components. The circuitry layer 640 may be connected to the detection elements 610. The circuitry layer 640 may comprise parallel layers of circuitry for connecting to each of the detection elements 610. Alternatively, the circuitry layer 640 may comprise a single layer with circuitry adjacent in cross-section for connecting to each of the detection elements 610.

Providing the circuitry layer 640 in the detector assembly is beneficial in that the circuitry can be close to the detection elements 10. The detection elements 610 are connected to circuitry to convert the detected signals into a digital signal. In general, having circuitry for converting the detected signal into a digital signal as close as possible to the relevant detection element beneficially improves the digital detection signal. A proximate digitization circuitry reduces risks of loss, or at least deterioration of, or disruption to the detection signal.

The circuitry layer 640 may comprise or be connected to the circuit layer and/or wiring as described above, e.g. in relation to **FIGS. 11A, 11B****,** and/or **12.**

For example, the detector circuitry may comprise a trans impedance amplifier 556 and/or an analog-to-digital converter 558 in electrical communication with the detection element 610. Preferably, the trans impedance amplifier 556 and/or an analog-to-digital-converter 558 is electrically connected to the detection elements 610. The circuitry layer 640 may comprise a trans-impedance amplifier and/or an analog-to-digital converter in each cell. Optionally, the circuitry layer may comprise a trans-impedance amplifier and/or an analog-to-digital converter for each of the respective detection elements 610 of the corresponding cell.

For example, the detector assembly 600 may comprise a wiring layer, which may optionally be part of the circuitry layer 640. Preferably, the wiring is routed between cells. The wiring layer may include the wiring routes 554 described above. The wiring layer may connect to the circuitry of a cell (e.g. relating to a single detection element 610) away from the apertures, e.g. defined through the cell array as described above. The wiring layer may comprise shielding between wiring connecting different cells. For example, the wiring layer may comprise a shielding arrangement as shown in and described above in relation to **FIG. 12****.** The cells may only be connected to each other via the wiring of the wiring layer. The wiring layer may be formed between and around the cells.

The circuitry layer 640 may be electrically connected to the detection element 610. For example, the detector assembly 600 may comprise electrical conductors 641 (which may be any electrical connector e.g. vias) so as to electrically connect the detection element 610 to detector circuitry. The electrical conductors 641 are for the detector assembly 600 to detect a signal particles through connection to the detection element 610. The circuitry layer 640 may be electrically connected to the detection element 610 through the isolating element 630. As shown in **FIG. 13****,** the electrical conductors 641 may extend through the shield element 620 and the isolating element 630. Specifically, the electrical conductors 641 may extend through the portion of the shield 620 which is positioned between the detection element 610 and the isolator element 630. Specifically, the electrical conductors 641 may extend through the isolating element 630 which is positioned between the detection element 610 and the shield element 620.

Different arrangements are possible and the electrical conductors 641 may only extend through components between the detection element 610 and the relevant part of the detector circuitry.

Additionally or alternatively, detector circuitry and/or wiring may be positioned within or as part of various components of the detector assembly 600. For example, at least part of the detector circuitry may be positioned in the isolating element 630.

Preferably, the isolating element 630 is provided as multiple layers which can be provided between conducting layers of the detector circuity in which electronic elements are provided. The layers of isolating element 630 can electronically insulate the different conducting layers. The conducting layers can be in electrical communication with each other via specific electrical conductors 641 as described above, e.g. vias.

Preferably, an aperture 660 is defined in the detector assembly 600 for the passage of the charged particle beam (i.e. the primary beam or sub-beam). The electrode elements may be arranged around the aperture 660. At least one detection element 610 may be associated with the aperture 660. The detection element 610 may be arranged around the aperture 660. The detection element 610 may define a corresponding aperture 660. In this case, the detection element 610 may surround the aperture 660, which may be beneficial for providing improved detection efficiency.

A single detection element 610 may correspond to each aperture, e.g. as a ring-shaped detection element 610. Alternatively, the at least one detection element 610 may comprise a plurality of detection elements 610 around a respective aperture 660. If the detection element 610 is a zoned detector element, the recess 606 may be provided between each of the zoned portions. Thus, the recessed surface 606 may be laterally recessed around at least one edge of each of the zoned portion. Preferably, the recessed surface 606 is laterally recessed around multiple, or all, edges of each zoned portion.

Although it may be beneficial to have the detection elements 610 surround a respective aperture such that signal particles can be captured by the detection element 610 all the way round the primary beam, other configurations may also be used and the detection element may be formed in any appropriate shape. For example, the detector assembly 600, or at least the detection element 610, may be provided to one side of an aperture for the primary beam path 320. This would allow the primary beam to reach the sample 208, and the detector assembly 600 can still detect signal particles emitted from the sample 208. In another configuration the detector assembly, and particularly the detection element 610, may be provided as at least two portions either side of an aperture for the path of the primary beam. In these configurations, a Wien filter may be used in combination with the detector assembly 600 for defecting signal particles towards the detection elements 610 at the side(s) of the aperture. The aperture 660 may be used for the passage of a single beam or multiple charged particle beams (i.e. a group of charged particle beams). If multiple primary beams (e.g. sub-beams) are provided, then the detector assembly may still be provided to one or both sides, for example, with slits for multiple sub-beam paths. In an embodiment, such a detector arrangement may have multiple detection elements 610 on one side of the slit. Such a configuration featuring a slit between detector assemblies or detector portions may be easy to manufacture. The aperture 660 of the detector assembly 600 in an electrostatic field may cause some disturbance of the field which may affect the primary sub-beam and it is preferable if the disturbance of the sub-beam is symmetric, because it leads to less deformation by aberrations.

The detection assembly 600 may define a plurality of apertures 660 as shown in **FIGS. 13-15****.** At least one detection element 610 may be associated with a respective aperture 660, i.e. at least one detection element 610 is provided for each aperture 660. At least one detection element 610 may be associated with a respective charged particle beam. In other words, a detection element 610 may be provided for each primary beam.

The detector assembly 600 may comprise a path shield 623 in at least one of the apertures. The path shield 623 may be configured to shield the detector assembly (i.e. components of the detector assembly) from charged particles through the passageway, and/or for shielding charged particles passing through the passageway. The path shield 623 may be part of the shield electrode 620, e.g. as depicted in **FIG. 13****,** or it may be a separate element. The path shield 623 may be used to shield components positioned around a passage way 670 defined by the aperture 660 or the respective apertures through the detector assembly. Thus, the path shield 623 may be provided on an internally facing surface of the detector assembly 600. The path shield 623 may be provided around a passageway defined by the aperture through the detector assembly. Preferably, the path shield 623 extends between the surfaces of the of the detector assembly, or at least the thickness of the circuitry layer 640. The path shield 623 may be through the substrate i.e. orthogonal to main surface of the detector assembly, irrespective as to whether the shield provides the surface of an aperture or not. The path shield 623 may laterally shield components of the detector assembly 600, such as detector circuitry. The path shield 623 may extend through the detector assembly. In embodiment, the path shield 623 may extend along most if not all the passageway 670 through the detector assembly.

Preferably, the path shield 623 provides at least part of a surface of the passage way 670, e.g. as shown in **FIG. 13****.** Thus, the path 623 shield may be provided on an internally facing surface of the detector assembly, adjacent to the path 320 of the charged particle beam(s). The path shield 623 may provide a surface of the passageway 670 at least along a down-beam portion of the passageway 670 as defined through the detector assembly 600. The path shield 623 may preferably extend from the main surface 605 of the detector assembly 600, i.e. the facing surface of the detector assembly 600. The path 623 shield may be provided on a side surface of the detector assembly, adjacent to the path 320 of the charged particle beam(s), for example if the detector assembly 600 is configured such that the charged particle beam passes adjacent to the detector assembly 600, rather than through it.

In an arrangement, a cavity 607 extends from the passageway 670. For example, as shown in **FIG. 13****,** the cavity 607 may extend between the inner surface 612 of the detection element 610 and the cavity surface 621B of the shield element 620. The surface of the cavity 607 may be defined by the inner surface 612, the cavity surface 621B and the portion 631 of the isolating surface interconnecting the inner surface 612 and the cavity surface 621B. The cavity 607 has an opening or gap defined in the surface of the through passage, e.g. between the detector element 610 and the shield element 620. The cavity 607 extends laterally in a radially outward direction from the passageway 670. The function of the cavity 607 is similar to the recess, for example to reduce the risk of short-circuiting between the electrode elements such as the detector element 610 and the adjoining electrode element, for example the shield electrode 620. Thus, the cavity 607 may be considered as a variant of the recess 606. But for the cavity, the interconnecting isolating surface would define in part the passageway 670. The cavity 607 is thus substantially similar in structure and function to the recess 606, but for the fact the cavity 607 extends laterally radially outwardly with respect to its respective aperture 660, rather than radially inwardly, up-beam of a detector electrode 610. The cavity 607 also extends linearly from its opening; that is the cavity does not feature a corner. In view of the orientation of the cavity 607 being substantially coplanar to the major surface, the chances of contamination are reduced. In an embodiment the recess 606 and the cavity 607 are interconnected through the isolating element 630.

The path shield 623 may protect charged particles passing through or adjacent to the detector assembly 600 in either direction. The path shield 623 may shield the primary sub-beam or groups of sub-beams. The path shield 623 may also be beneficial in shielding signal charged particles, for example if a further detector assembly is provided up-beam (along the primary beam path 320 towards the source) of the detector assembly 600. The path shield 623 is connected to a voltage source, for example ground. The path shield maybe considered a type of electrode element for the passageway 670.

The path shield 623 may be integral with other parts of the shield element 620 as shown in **FIG. 13****.** Even though the path shield 623 is shown as integral in **FIG. 13****,** it could be provided as a separate component. Thus, the path shield 623 may be separate from at least another part of the shield 620 (for example as shown in **FIG. 14** described in further detail below). Whether or not the path shield 623 is provided integrally will generally depend on the overall shape of the shield, dimensions, manufacturing, and whether or not a part of the shield 620 extends to the aperture 660 of the detector assembly 600 such that it can connect to the path shield 623. Even if the main body of the shield 620 and the path shield 623 are in contact, they could be connected or attached together rather than being formed as a single piece.

A different configuration is shown in **FIG. 14****.** The configuration described in relation to **FIG. 14** may have any features as described in relation to **FIG. 13****,** except for the differences described herein.

Although it is shown in **FIG. 13** that the recess extends laterally behind only the detection elements 610, the recess may also extend laterally behind the shield elements 620, e.g. as in **FIG. 14****.** The recess 606 may extend laterally behind each type of electrode element, i.e. behind shield elements 620 and/or detection elements 610 and/or path shields 623 (which may be referred to as a cavity 607). The recessed surface may extend laterally behind both electrode elements adjacent to the recess. The recessed surface may extend laterally behind each (i.e. every) electrode element. The recessed surface 606 may be recessed around a perimeter of each electrode element. Thus, the cavity 607 may also extend laterally behind the path shield 623 as will be described.

As shown in **FIG. 14****,** the path shield 623 may be separate from at least another part of the shield 620. The path shield 623 may have a corresponding recess, which may be referred to as cavity 607 as described for **FIG. 13****,** between the path shield 623 and an adjacent electrode element, e.g. between the path shield 623 and the detection element 610, as shown in **FIG. 14****.** The cavity 607 extends radially outwardly with respect to the path shield 623 and away from the detector element 610. Although the path shield 623 is separate from the shield element 620 in **FIG. 14****,** these components could be integral, e.g. as in **FIG. 13****.**

As shown in **FIG. 14** the recess may be provided in a different shape to that shown in **FIG. 13****.** For example, a significant lateral recess can be realized having a hemispherical shape as in **FIG. 14****.** The dimension of the recessed surface in the lateral direction may be the same as described in relation to **FIG. 13****.** However, the hemispherical shape of the recess in **FIG. 14** means that the isolator surface is approximately equidistant from the gap at all points of the isolator surface. This is beneficial in the configuration shown in **FIG. 14** in which the isolator surface, on which contamination may build up, provides more of the recessed surface.

The deeper hemispherical recess of **FIG. 14** might provide similar advantages in reducing or avoiding contamination as in **FIG. 13****.** However, the hemispherical recess requires additional space compared to the arrangement shown in **FIG. 13** and thus, may limit space for other components, such as for circuitry. Alternatively, the detector assembly may need to be bigger to accommodate the recess as in **FIG. 14** which can negatively affect cross-talk between neighboring detections elements or electron-optical performance.

As with **FIG. 13****,** the recessed surface in the configuration of **FIG. 14** is at least partially comprised of the isolating surface of the isolating element. The isolating surface is beneficially spaced away from the gap between the electrode elements so that contamination does not build up to permit shorting.

As shown for example in **FIG. 14****,** the whole of a shield element 620 may be positioned between detection elements 610, at least in cross-section. In such an arrangement the detector elements 610 may be coplanar with the shield elements 620, i.e. the whole elements as well as the surface of the elements may be coplanar.

Electrical conductors 641 may extend through the isolating element 630 without extending through the shield element 620 (because the shield element is not positioned between the detection element 610 and the isolating element 630), for example, as shown in **FIGS. 14** (and **15** described further below).

Furthermore, it is described above that the detector assembly 600 comprises a detection element 610 and a shield element 620. However, more generally the detector assembly 600 may comprise a plurality of electrode elements, each electrode element having its own major surface. At least one of the electrode elements is a detection element 610 as described above. At least one of the electrode elements may be a shield element 620 as described above. Preferably the electrode elements comprise exclusively detection elements 610 and shield elements 620.

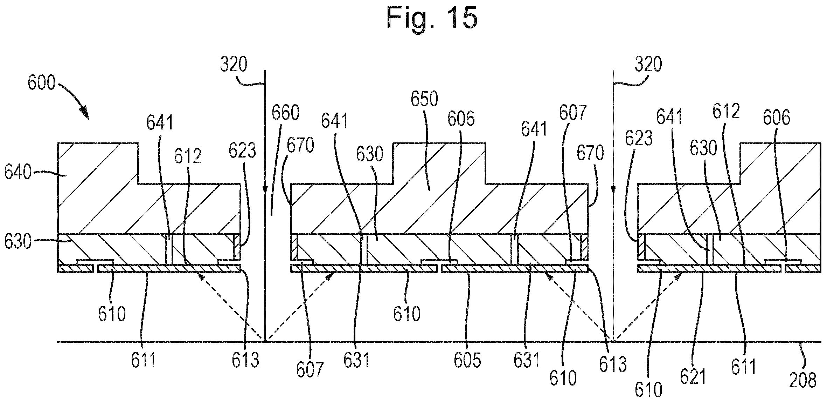

Alternatively, the detector assembly 600 may be provided without a shield element 620. Thus, as shown in **FIG. 15****,** all the electrode elements may be detection elements 610. It will be noted that the recess 606 of **FIG. 15** is a similar shape to the recess of **FIG. 13****.** However, the recess 606 may be provided in other shapes, dimensions and configurations, for example as a hemispherical shape as in **FIG. 14****.** For example the lateral extent of the recess 606 is depicted as being shorter than the arrangement shown in **FIG. 13****.** As the detector assembly of **FIG. 15** as depicted does not include a shield element 620 between the detector elements, there may be increased cross-talk compared with the detector assembly as shown in **FIG. 13** and **FIG. 14** in variations without a shield element 620. Thus, the arrangement as shown in **FIG. 15** without a shield element 620 may be particularly suited for a single beam system, which may comprise multiple detector elements associated with the single beam. However, in an alternative arrangement, a layer under the detector elements 610 with respect to the major surface of the detector elements 610, many serve as and be configured to operate as a shield electrode 620. For example, a shield element 620 could be provided to form surfaces of the cavities 607 and recess 606, e.g. by extending from the base of one path shield 623 (as shown in **FIG. 15**) to the base of another path shield 623 through the isolating element 630. Such a shield electrode may be connected to or even comprise path shields 623 in the respective passageway 670. The shield electrode may provide some of the benefits here in described and ascribed to the shield detector shown in and described with respect to **FIG. 13****.**

The laterally recessed surface may be provided in any appropriate shape or geometry, namely in three-dimensions, to define the recess 606. For example, the recess 606 may substantially form a ring shape or cuboid behind the detection element 610 (and/or other electrode elements) as shown in **FIGS. 13** and **15****.** This may allow for more compact configuration and/or more space for other components of the detector assembly 600. Additionally, the recess 606 as described in relation to **FIG. 13** may be more easily cleaned, e.g. by plasma cleaning, than other shapes. In an alternative configuration, the recess 606 may substantially form a hemisphere behind the detection element 610 (and/or other electrode elements) as shown in **FIG. 14****.** Other shapes may also be provided, e.g. a cone, pyramid, or half cylinder.

Although the major surfaces of the electrode elements are preferably provided in a planar surface of the detector assembly 600, alternatively the major surfaces may not be aligned in the same plane. For example, at least some of the major surfaces may be offset, e.g. in the direction of the primary beam path 320, compared to at least one other major surface. Alternatively, the major surfaces may form an acute or obtuse angle with a plane substantially orthogonal to the primary beam path 320. In other words, at least one of the major surfaces may not be coplanar with the sample and/or sample support. The major surfaces may not be coplanar with each other.

The detection element 610 in any of the above variations may be any appropriate type of detector. For example, the detection element 610 may comprise a charge detector and/or a semiconductor detector and/or a scintillating detector. Other types of detector may be used alternatively or in addition.

The detection element 610 may comprise a single type of detector. For example, the detection element 610 may be a charge detector. The charge detector could be provided as a metal layer, which may be a planar portion. Signal particles with an energy of less than 50 eV (which may correspond to the secondary signal particles described above) can be 'captured' by a charge detector with a relatively small thickness (e.g. of approximately 100 nm or less).

The detection element 610 may comprise at least two or more types of detector. This may be beneficial for detecting different types of signal particles. In this case, the two or more types of detector are preferably layered along the beam path, i.e. the different types of detector are preferably stacked (or layered) in a direction parallel to the beam path 320. Thus, detection surfaces (i.e. major surfaces) of the different detectors may be substantially parallel. The two or more types of detector may comprise a charge detector, e.g. as described above. The charge detector is preferably provided as a surface layer to other detectors, i.e. the charge detector preferably forms an outermost layer of the detection element 610. Thus, the charge detector may provide the major surface 611 of the detection element 610. Lower energy signal particles may be captured by the charge detector. The vast majority of higher energy signal particles will pass though the charge detector to the other detector(s). Providing a relatively small thickness of the charge detector (e.g. approximately 100 nm or less) is beneficial in allowing signal particles to reach the other detector(s).

The other type of detector may comprising a semiconductor type detector (such as a PIN diode or avalanching photodiode) and/or a scintillating type detector (preferably in addition to the charge detector). The semiconductor and/or scintillating type detector can be used to detect the higher energy signal particles. In the case of a scintillating detector, the signal particles can be converted into photons which may be detected by a photon detector which may or may not be part of the detector assembly 600.

In any of the above embodiment, the collection efficiency may be improved by applying a bias between the sample 208 and the detector assembly 600 to attract the signal particles to the detection elements 610. Thus, a potential may be applied to the detection element 610, for example as described in relation to **FIG. 5****.** Similarly, a potential, which may be the same as applied to the detection elements 610, may be applied to any shield elements 620 which are provided. Typically, the potential of all surfaces facing the substrate (i.e. of the electrode elements) are the same. In practice the bias is preferably applied jointly to all electrode elements of the detector assembly. The potential difference may be referred to as a bias voltage.

The potential may be relatively small. For example, the potential difference between the sample 208 and the detector assembly may be approximately 100 V or less. For example, the potential difference may be approximately -50V to + 300V, or preferably >0V to + 300 V, or preferably +50 V to +300 V. The potential difference between the detector elements 610 and the shield elements 620 to ensure a sufficiently detectable detection signal may be caused by finite gain of the amplifier, which may be of the order of 50 mV. The electrode elements may be more positive than the sample 208. Thus, the potential difference may be used to attract signal particles to the detector assembly. Such an accelerating voltage (e.g. around 50 V - 300V) is small compared the difference in energy between lower energy signal particles (e.g. secondary signal particles with a maximum energy of approximately 50 eV) and higher energy signal particles (e.g. backscatter signal particles with a maximum energy up to the landing energy of keV's or more). It will be noted that a small potential difference will tend to have a greater effect on the lower energy particles, such as those corresponding to the secondary signal particles. Of course, the same potential may be applied to a single detector assembly, e.g. when provided as part of a single beam device.

Although the figures described above generally include multiple apertures, it will be understood that a single aperture could be provided. The single aperture could be used for the passage there through of a single charged particle beam or multiple charged particle beams. The single aperture may have a single detector element and a single shield element, or multiple detector elements optionally in combination with one or more shield elements.

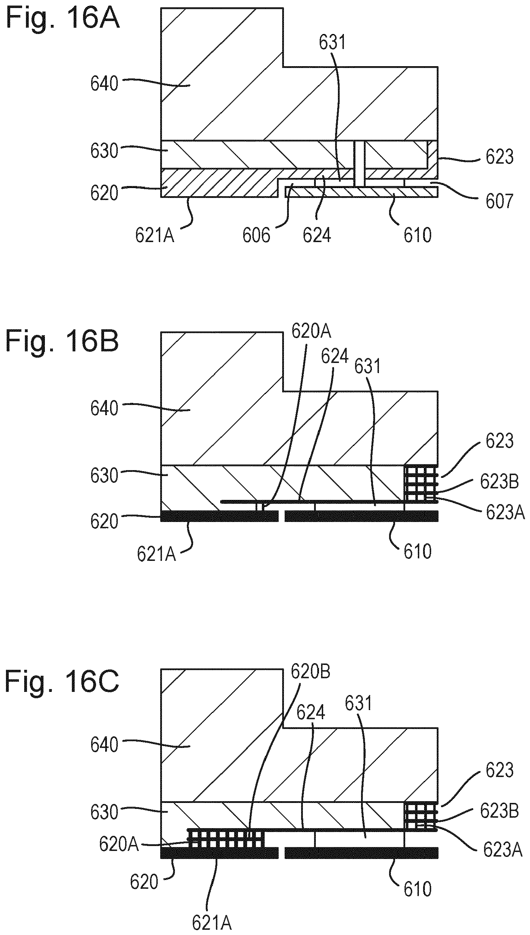

It is noted that the above description of the detector assembly provides details of the geometry of different configurations. The detector assembly as described in any of the variations above may be fabricated using any appropriate fabrication method, for example only, the detector assembly may be at least partly fabricated using CMOS (complementary metal-oxide-semiconductor). For example, various elements described in relation to **FIGS. 13-15** in particular can be fabricated using commercially available CMOS processes, such as described in US20110266418A1 filed on 26 October 2010, which is hereby incorporated by reference. In particular, the subject matter relating to an electron optical device fabricated using a standard CMOS process which is post processed using wet etch to remove oxides US20110266418A1 is disclosed herein by reference. Additionally or alternatively, various elements described in relation to **FIGS. 13-15** in particular can be fabricated using a standard CMOS process which is post processed using Deep Reactive Ion Etching to etch through substrate holes and wet etch to remove oxides. Although other fabrication methods may also be used, details of how CMOS may be used is described below in relation to **FIGS. 16A-16C****.**

**FIG. 16A** is a section of **FIG. 13** wherein only part of the detector assembly is shown; the same features taking the same references as herein described unless otherwise stated to the contrary. **FIGS. 16B** and **16C** are provided to show how the structure of electrode elements, e.g. the shield element 620, detection element 610, the isolating element 630 and the path shield 623, may be formed. The electrode elements can be formed in the interconnect layers of the CMOS device. Specifically, the electrode elements may each be formed of conductive elements, which are provided as the parallel layers, which are connected by one or more via between each layer. The layers and vias may form a stacked structure.

For example, as shown in **FIG. 16B****,** at least one layer forms the part of the shield element 620 which provides major surface 621A. At least one layer forms the portion 624 of the shield element 620. In **FIG. 16B****,** these layers are connected by at least one via 620A. In **FIG. 16C****,** the shield element comprises an intermediate layer 620B of the shielding element 620 which is connected to the other layers by vias. There may be multiple intermediate layers with at least one via between each layer.

As shown in **FIGS. 16B** and **16C****,** providing at least one intermediate layer varies the vertical distance of the portion 624 of the shield element 620 from the major surface 621A. As the distance between these parts of the shield element 620 is increased by providing additional intermediate layers as in **FIG. 16C** compared to **FIG. 16B****,** the thickness of the portion 621 of the isolating element 630 is increased in **FIG. 16C** as compared to **FIG. 16B****.**

As shown in **FIGS. 16B** and **16C****,** the portion 624 of the shield element 620 may be connected to, or form, the lowest layer, or most down-beam layer, of the path shield 623. The path shield 623 is also provided by a stacked structure of vias 623A and intermediate layers 623B. When the portion 624 is connected to, or forms, the lowest layer of the path shield 623, the number of intermediate layers 623B of the path shield 623 will depend on the number of intermediate layers between the major surface 621A and the portion 624.

Certain layers of the electrode elements may be formed at the same level. For example, it is described above that the major surface 621A of the shielding element 620 may be coplanar with the major surface 611 of the detection element 610. In the context of the CMOS structure, this would mean that the layers of each electrode forming these surfaces are provided in the same level of the CMOS structure, which makes them coplanar.

Different types of CMOS process may be used. The material used for the isolating element 630 and/or the portion 631 of the isolating element preferably comprises, or consists of, SiO₂. Typically the SiO₂ is doped, or porous. Other materials may be used for the isolator, e.g. such as those described in https://en.wikipedia.org/wiki/Low-%CE%BA_dielectric. Preferably, the detector and/or shield elements are made from aluminum. In this case, the fabrication preferably comprises an "aluminum interconnect" process (such as TSMC 180nm). Alternatively (and less preferred), the detector and/or shield elements can be made from copper. In this case, the fabrication method may comprise a CMOS process that uses copper interconnects. Use of copper enables features of smaller dimension.

Material forming the isolating element 630 may be removed to form a lateral recess as described above,. For example, to remove the material forming the isolating element 630 (which is preferably SiO₂) in the lateral direction an isotropic etch is preferred. In general, wet etchants etch isotropically. For example, buffered oxide etching (BHF) is a well known etch to etch SiO₂, (which is a typical isolator used in CMOS structures, for example, see https://en.wikipedia.org/wiki/Buffered_oxide_etch) and could be used. During such etching steps, the shield element 620 may be beneficial in protecting other components of the detector assembly from the wet etch that is used to remove the isolating material laterally.

Although both figures 16B and 16C show at the shield element extends to connect to the path shield 630 via portion 624, this is not a necessity.

Different component parts of the detector assembly 600 may be formed as layers of the substrate 650 for example using semiconductor fabrication processes described above. Additionally or alternatively, components parts may be attached together. For example, the detection element 610 may be attached to other components of the assembly body, e.g. the main body 650 and/or the shield 620 using, for example, adhesive, welding or some other attachment method. In other words, any appropriate fabrication method and means of attachment, if needed, can be used to produce the detector assembly.

The present invention may provide a charged particle assessment device (e.g. a column) for detecting signal particles emitted by the sample 208 in response to a charged particle beam. The detector assembly 600 described in any of the above variations may be provided as part of a single-beam assessment device, e.g. as described in relation to **FIG. 10****.** The charged particle assessment device may comprise an objective lens configured to project the charged particle beam onto the sample, e.g. as described in any of the variations above, for example, an objective lens of objective lens array 241 or objective lens assembly 132. An aperture may be defined in the objective lens for the charged particle beam and the detector assembly may define a corresponding aperture. Preferably the aperture of the objective lens and the aperture of the detector assembly are aligned.

The present invention may provide a charged particle assessment device for detecting signal particles emitted by a sample in response to a plurality of charged particle beams. The detector assembly 600 described in any of the above variations may be provided as part of a multi-beam assessment device, e.g. as described in relation to **FIGS. 3-9****.** The charged particle assessment device may comprise an objective lens configured to project the plurality of charged particle beams onto the sample in a multi-beam array, e.g. as described in any of the variations above, for example, the objective lens array 241. At least one aperture may be defined in the objective lens for a charged particle beam or a group of charged particle beams. The detector assembly 600 may define a corresponding aperture. Preferably each aperture of the objective lens array 241 is aligned with an aperture of the detector assembly 600. Preferably, there is an aperture in the objective lens array 241 and a corresponding aperture in the detector assembly 600 for each charged particle beam or group of sub-beams. Thus, there may be corresponding arrays of objective lens apertures and detector assembly apertures for the passage of the array of sub-beams. When the detector assembly is used with an array of apertures, e.g. for corresponding to an array of apertures of the objective lens array, the detector assembly may otherwise be referred to as a detector array.

The present invention may provide the assessment apparatus (e.g. which may otherwise be referred to as an assessment or inspection tool) for detecting signal particles emitted by a sample in response to a charged particle beam or a plurality of charged particle beams. The assessment apparatus comprising an assessment device as described above, or an assessment device comprising a detector assembly 600 as described above. The assessment apparatus further comprises sample holder 207 (or any general support for supporting the sample 208).

The detector assembly 600 may be associated with the objective lens array 241. For example, the detector assembly 600 may be structurally connected to the objective lens array 241. Thus, the detector assembly 600 may be positioned on, attached, or directly connected to the objective lens. Specifically, the detector assembly 600 may be associated with a major surface of an electrode plate of the objective lens array 241. Thus, the detector assembly 600 may be structurally connected to an electrode of the objective lens array 241. The detector assembly 600 may be positioned adjacent to, or structurally connected to the most down-beam electrode of the objective lens array 241. The detector assembly 600 may be positioned adjacent to, or structurally connected to, a down-beam surface of the most down-beam electrode of the objective lens array 241. The detector assembly 600 could be positioned adjacent to, or structurally connected to, the most up-beam electrode of the objective lens array 241. If the detector assembly 600 is part of the detector arrangement, the detector arrangement may be associated with the objective lens array 241 as described herein. The objective lens array 241 could be replaced with a single objective lens or objective lens assembly 132.

Preferably, the detector assembly 600 is positioned proximate to the sample 208 (when in position) and/or support 207. Thus, the detector assembly 600 is preferably provided between the bottom electrode 243 and the sample 208 and/or sample holder 207. It is beneficial to provide the detector assembly 600 proximate the sample 208 because this is where the greatest contamination is likely to occur. Thus, this is where the detector assembly 600 of the present invention might provide the greatest improvement. Preferably the detector assembly 600 is adjacent the sample. Preferably the detector assembly 600 is directly adjacent the sample 208 and there are no other components between the detector assembly 600 and the sample 208. Preferably, the detector assembly 600 is facing the sample 208 (when in position) and/or sample holder 207.

Even though this is the preferred positioned of the detector assembly 600, the detector assembly could be positioned elsewhere, e.g. as described in relation to **FIG. 8****.** Alternatively, an additional detector assembly could be provided in another location, e.g. as described in relation to **FIG. 8****.**

The present invention may also provide a method of detecting signal particles using any of the detector assemblies, detector arrangements, or charged particle devices as described above.

A method is provided of projecting a beam of charged particles onto a sample 208 so as to detect signal particles emitted from the sample 208, the method comprising a) projecting the charged particle beam along a primary beam path onto a surface of the sample 208; and b) detecting signal particles at a detector assembly 600. The detector assembly 600 may be as described in any of the above variations.

As mentioned above, only a single charged particle beam may be used. Alternatively, the beam can be multi-beam on impact with the sample 208, the multi-beam comprising a plurality of sub-beams. Preferably the detecting of signal particles comprising detecting signal particles derived from a different sub-beam impacting the sample 208 using a plurality of the detector elements 610 comprised by at least some of the electrode elements.

Also provided is a method of processing a resist covered sample. The method comprising projecting a patterned beam of (preferably photonic) radiation onto the resist covered sample 208 so as to pattern the resist on the sample 208. The method comprising carrying out the method steps described above. The patterning step should be carried out prior to the other method steps. As previously described, the resist may be a source of contamination in the detector. Of course, contamination may occur even if not using resist, however, resist is more likely to be a source of contamination and thus is more likely to cause a problem.

In the present description, it will be understood that the charged particles/signal particles are generally intended to be electrons, or other negatively charged particles. However, contrary to the above, the charged particles/signal particles may be positively charged particles, e.g. ions. Thus, a primary ion beam may be provided. With a primary ion beam, secondary ions could be emitted from the sample that could be detected by the charge based type detector. However, this would also generate negative charged particles, e.g. secondary electrons at the same time. So the charge accumulated with this charge based type detector will be a mix of positively and negatively charged particles, which would make the charged measurement unreliable. However, having either a positive or negative bias on the charge based type detector would make it possible to choose one of the charge polarities. Because of the much smaller range of ions than electrons in a material, backscatter ions need a much larger kinetic energy to be able to reach any further detectors, e.g. the scintillator and/or semiconductor type detector. Thus, not all backscatter ions will make it to this detector component. To improve the detection of backscatter ions, the charge based type detector could be made thinner. In the instance that ions are used instead of negatively charged particles, then any bias referred to above would be opposite, e.g. a positive bias should be used instead of a negative one and vice versa.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The charged-particle optical device may be a negative charged particle device. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle-optical device may more specifically be defined as a charged particle-optical column. In other words, the device may be provided as a column. The column may thus comprise an objective lens array assembly as described above. The column may thus comprise a charged particle optical system as described above, for example comprising an objective lens array and optionally a detector array and/or optionally a condenser lens array.

The charged particle optical device described above comprises at least the objective lens array 240. The charged particle optical device may comprise the detector array 241 and/or detector assembly 600. The charged particle optical device may comprise the control lens array 250. The charged particle optical device comprising the objective lens array and the detector array may thus be interchangeable with, and referred to as, the objective lens array assembly, which may optionally comprise the control lens array 250. The charged particle optical device may comprise additional components described in relation to either of **FIG. 3** and/or **FIG. 9****.** Thus, the charged particle optical device may be interchangeable with, and referred to as, a charged particle assessment tool 40 and/or an charged particle optical system if comprising the additional components in these figures.

References to up and low, upper and lower, lowest, up and down, above and below should be understood as referring to directions parallel to the (typically but not always vertical) upbeam and downbeam directions of the electron beam or multi-beam impinging on the sample 208. Thus, references to up beam and down beam are intended to refer to directions in respect of the beam path independently of any present gravitational field.

References to elements being aligned along a beam path or sub-beam path are understood to mean that the respective elements are positioned along the beam path or sub-beam path.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a microelectromechanical system (MEMS) (i.e. using MEMS manufacturing techniques).

The system or device of such architectures as depicted in at least **FIGS. 3** and **9** and as described above may comprise components such as an upper beam limiter, a collimator element array 271, a control lens array 250, a scan deflector array 260, an objective lens array 241, a beam shaping limiter and/or a detector array 241 and/or detector assembly 600 ; one or more of these elements that are present may be connected to one more adjacent elements with an isolating element such as a ceramic or glass spacer.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260, 265) to operate on the charged particle beam in the charged particle beam path. Additionally or alternatively, in an embodiment the controller 50 controls at least one charged particle-optical element (e.g. the detector array 241 and/or detector assembly 600) to operate on the charged particle beam emitted from the sample 208 in response to the charged particle beam.

Any element or collection of elements may be replaceable or field replaceable within the charged particle beam tool 40. The one or more charged particle-optical components in the charged particle beam tool 40, especially those that operate on sub-beams or generate sub-beams, such as aperture arrays and manipulator arrays may comprise one or more MEMS.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses: Clause 1: A detector assembly for a charged particle assessment apparatus, the detector assembly comprising a plurality of electrode elements, each electrode element having a major surface configured to be exposed to signal particles emitted from a sample, wherein between adjacent electrode elements is a recess that is recessed relative to the major surfaces of the electrode elements, and wherein at least one of the electrode elements is a detection element configured to detect signal particles and the recess extends laterally behind the detection element.

Clause 2: The detector assembly of clause 1, wherein the recess extends laterally behind each electrode element.

Clause 3: The detector assembly of either of clauses 1 or 2, wherein the major surfaces of the electrode elements are in a main planar surface of the detector assembly.

Clause 4: The detector assembly of any one of the preceding clauses, wherein the recess is recessed around at least part of a perimeter of each detector element, preferably of each electrode element.

Clause 5: The detector assembly of any one of the preceding clauses, wherein the major surface of each electrode element provides an outer surface of the electrode element, and each electrode element has an inner surface facing an opposing direction to the outer surface, preferably wherein part of the inner surface is part of a recessed surface which defines the recess.

Clause 6: The detector assembly of any one of the preceding clauses, further comprising an isolating element configured to support the electrode elements, preferably wherein part of a surface of the isolating element is part of a recessed surface which defines the recess, preferably the isolating element is one or more layers.

Clause7: The detector assembly of clause 6, wherein at least part of the detector circuitry is positioned in the isolating element.

Clause 8: The detector assembly of any one of the preceding clauses, further comprising a circuitry layer comprising detector circuitry which is electrically connected to the detector element through the isolating element.

Clause 9: The detector assembly of any one of the preceding clauses, wherein at least one of the electrode elements is a shield element for shielding components within the detector assembly, preferably wherein a surface of the shield element is at least part of a recessed surface which defines the recess, preferably at least one shield element comprising a layer preferably providing a facing surface of the detector assembly for facing a sample.

Clause 10: The detector assembly of clause 9, wherein the shield element is positioned between adjacent detector elements, preferably wherein the major surface of the shield element is coplanar with the major surface of the detector element

Clause 11: The detector assembly of either of clauses 9 or 10, wherein a portion of the shield element extends parallel to the major surface of the detector element, the portion of the shield element being behind at last part of the detector element.

Clause 12: The detector assembly of clause 11, further comprising electrical conductors through the shield portion so as to electrically connect the detector element to detector circuitry, the electrical conductors preferably extending through an isolating element.

Clause 13: The detector assembly of either of clauses 11 or 12, wherein a portion of the isolating element is positioned between the shield element and the detector element.

Clause 14: The detector assembly of any one of the preceding clauses, wherein the detector element comprises at least two or more types of detector, preferably the two or more types of detector are layered along the beam path, the two or more types of detector comprising a charge detector preferably as a surface layer to one or more of the detector elements, preferably the two or more types of detector comprising a semiconductor type detector and/or a scintillating type detector.

Clause 15: The detector assembly of any preceding clause, wherein in the detector assembly is defined an aperture for the passage of a charged particle beam, preferably wherein the electrode elements are arranged around the aperture, preferably the electrode elements are arranged in a two dimensional array.

Clause 16:The detector assembly of clause 15, wherein in the detector assembly is defined a plurality of apertures, at least one detector element being associated with a respective aperture.

Clause 17:The detector assembly of clause 15 or 16, wherein the at least one detector element comprises a detector element in which the corresponding aperture is defined.

Clause 18: The detector assembly of clause 15 or 16, wherein the at least one detector element comprises a plurality of detector elements around a respective aperture.

Clause 19: The detector assembly of any preceding one of clauses 15 to 18, further comprising a path shield around a passage way defined by the aperture through the detector assembly, the path shield configured to shield the detector assembly from charged particle beam through the passage way, preferably the path shield providing at least part of a surface of the passage way, preferably around each passageway is a path shield.

20. A detector assembly for a charged particle assessment apparatus, the detector assembly comprising a plurality of detector elements each configured to detect signal electrons, each detector element having a major surface configured to face towards a sample support configured to support a sample, the detector elements being arranged in a two dimensional array wherein adjoining each detector electrode is a recessed surface that is recessed relative to the major surface of the respective detector electrode, the recessed surface extending behind at least the respective detector electrode.

21. A charged particle assessment device for detecting signal particles emitted by a sample in response to a charged particle beam, the assessment apparatus comprising: an objective lens configured to project the charged particle beam onto the sample; and the detector assembly of any one of clauses 1 to 20.

22. A charged particle assessment device for detecting signal particles emitted by a sample in response to a charged particle beam, the assessment apparatus comprising: an objective lens configured to project the charged particle beam onto the sample; and the detector assembly of any one of clauses 1 to 15, wherein an aperture is defined in the objective lens for the charged particle beam and the detector assembly defines a corresponding aperture, preferably wherein the electrode elements are arranged around the aperture.

23. A charged particle assessment device for detecting signal particles emitted by a sample in response to a plurality of charged particle beams, the assessment apparatus comprising: an objective lens array configured to project a plurality of charged particle beams onto a sample in a multi-beam array; and the detector assembly of any one of clauses 1 to 20.

24. A charged particle assessment device for detecting signal particles emitted by a sample in response to a plurality of charged particle beams, the assessment apparatus comprising: an objective lens array configured to project a plurality of charged particle beams onto a sample in a multi-beam array; and the detector assembly of any one of clauses 1 to 15, wherein in the objective lens array is defined an aperture for at least one charged particle beam and in the detector assembly is defined a corresponding aperture, preferably wherein at least one detector element corresponds to each charged particle beam.

25. An assessment apparatus for detecting signal particles emitted by a sample in response to a charged particle beam, the assessment apparatus comprising: an assessment device of any of clauses 21 to 24 or an assessment device comprising a detector assembly of any of clauses 1 to 20; and a support for supporting the sample.

26. The assessment apparatus of clauses 25, wherein the detector assembly is positioned a) proximate to the sample and/or support, and/or b) facing the sample and/or support.

27. A method of projecting a beam of charged particles onto a sample so as to detect signal particles emitted from the sample, the method comprising: a) projecting the charged particle beam along a primary beam path onto a surface of the sample; and b) detecting signal particles at a detector assembly, the detector assembly comprising a plurality of electrode elements, each electrode element having a major surface configured to be exposed to signal particles emitted from a sample, wherein between the electrode elements is a recess that is recessed relative to the major surfaces of the electrode elements, and wherein at least one of the electrode elements is a detection element configured to detect signal particles and the recess extends laterally behind the detection element.

28. The method of clause 27, wherein the beam is a multi-beam on impact with the sample, the multi-beam comprising a plurality of sub-beams, preferably the detecting of signal particles comprising detecting signal particles derived from a different sub-beam impacting the sample using a plurality of the detector elements comprised by at least some of the electrode elements.

29. A method of processing a resist covered sample comprising projecting a patterned beam of (preferably photonic) radiation onto the resist covered sample so as to pattern the resist on the sample, and further comprising carrying out the method of either of clauses 27 or 28.

## Claims

1. A detector assembly for a charged particle assessment apparatus, the detector assembly comprising a plurality of electrode elements, each electrode element having a major surface configured to be exposed to signal particles emitted from a sample, wherein between adjacent electrode elements is a recess that is recessed relative to the major surfaces of the electrode elements, and wherein at least one of the electrode elements is a detection element configured to detect signal particles and the recess extends laterally behind the detection element.

2. The detector assembly of claim 1, wherein the recess extends laterally behind each electrode element.

3. The detector assembly of either of claims 1 or 2, wherein the major surfaces of the electrode elements are in a main planar surface of the detector assembly.

4. The detector assembly of any one of the preceding claims, wherein the recess is recessed around at least part of a perimeter of each detector element, preferably of each electrode element.

5. The detector assembly of any one of the preceding claims, wherein the major surface of each electrode element provides an outer surface of the electrode element, and each electrode element has an inner surface facing an opposing direction to the outer surface, preferably wherein part of the inner surface is part of a recessed surface which defines the recess.

6. The detector assembly of any one of the preceding claims, further comprising an isolating element configured to support the electrode elements, preferably wherein part of a surface of the isolating element is part of a recessed surface which defines the recess, preferably the isolating element is one or more layers.

7. The detector assembly of any one of the preceding claims, further comprising a circuitry layer comprising detector circuitry which is electrically connected to the detector element through the isolating element.

8. The detector assembly of any one of the preceding claims, wherein at least one of the electrode elements is a shield element for shielding components within the detector assembly.

9. The detector assembly of claim 8, wherein the shield element is positioned between adjacent detector elements, preferably wherein the major surface of the shield element is coplanar with the major surface of the detector element

10. The detector assembly of either of claims 8 or 9, wherein a portion of the shield element extends parallel to the major surface of the detector element, the portion of the shield element being behind at last part of the detector element.

11. The detector assembly of claim 10, wherein a portion of the isolating element is positioned between the shield element and the detector element.

12. The detector assembly of any preceding claim, wherein in the detector assembly is defined an aperture for the passage of a charged particle beam.

13. The detector assembly of claim 12 wherein in the detector assembly is defined a plurality of apertures, at least one detector element being associated with a respective aperture.

14. The detector assembly of claim 12 or 13, wherein the at least one detector element comprises a detector element in which the corresponding aperture is defined.

15. The detector assembly of any preceding one of claims 12 to 14, further comprising a path shield around a passage way defined by the aperture through the detector assembly, the path shield configured to shield the detector assembly from charged particle beam through the passage way.
